(19) Europäisches Patentamt
European Patent Office
Office européen des brevets

(11) **EP 2 116 901 B1**

(12) **EUROPÄISCHE PATENTSCHRIFT**

(45) Veröffentlichungstag und Bekanntmachung des Hinweises auf die Patenterteilung:
**14.09.2016 Patentblatt 2016/37**

(51) Int Cl.:
*G03F 7/20* (2006.01)    *G03B 27/32* (2006.01)
*H04N 1/195* (2006.01)

(21) Anmeldenummer: **09005359.6**

(22) Anmeldetag: **15.04.2009**

(54) **Hochauflösendes Fotoplottverfahren und Anordnung zur hochauflösenden Aufzeichnung eines computergespeicherten Rasterbildes auf einen ebenen lichtempfindlichen Aufzeichnungsträger**

High resolution photo plot method and assembly for recording a high resolution halftone image stored on a computer on a level photosensitive recording medium

Procédé de phototraçage à haute résolution et agencement d'enregistrement à haute résolution d'une trame stockée sur ordinateur sur un support d'enregistrement plat sensible à la lumière

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **06.05.2008 DE 102008022253**

(43) Veröffentlichungstag der Anmeldung:
**11.11.2009 Patentblatt 2009/46**

(73) Patentinhaber: **Pagan, Robin**
**70563 Stuttgart (DE)**

(72) Erfinder: **Pagan, Robin**
**70563 Stuttgart (DE)**

(74) Vertreter: **Blutke, Klaus Wilhelm**
**Schafgasse 1**
**71032 Böblingen (DE)**

(56) Entgegenhaltungen:
**EP-A- 0 987 875      EP-A- 1 345 406**
**US-A- 5 995 129**

EP 2 116 901 B1

**Beschreibung**

Die Erfindung bezieht sich auf ein Fotoplott-Verfahren und eine Anordnung zur Aufzeichnung eines computergespeicherten Rasterbildes auf einen ebenen lichtempfindlichen Aufzeichnungsträger.

Fotoplottverfahren und -Anordnungen dienen z.B. der Herstellung fotographischer Vorlagen für gedruckte Leiterplatten.

Nach dem Stand der Technik sind eine Vielzahl unterschiedlicher Verfahren und Anordnungen bekannt.

Der in dieser Schrift beschriebenen Erfindung kommt das in der Deutschen Patentanmeldung 10 2007 051 990.9-31 beschriebene Fotoplott-Verfahren und die in dieser Patentannmeldung 10 2007 051 990.9-31 beschriebene Anordnung zur Aufzeichnung eines computergespeicherten Rasterbildes auf einen ebenen lichtempfindlichen Aufzeichnungsträger am nächsten.

Gemäß dieser Deutschen Patentanmeldung 10 2007 051 990.9-31 wird das aufzuzeichnende Rasterbild T (Gesamtbild) wird computerprogrammgesteuert bildpunktweise als Folge von Teilbildern aufgezeichnet auf einen sich in Richtung v durch eine Belichtungsstation hindurchbewegenden Aufzeichnungsträger. Alle Bildpunkte eines Teilbildes werden gleichzeitig aufgezeichnet.

Die Teilbilder werden zu Blitzzeitpunkten aufgezeichnet, zu denen sich der Aufzeichnungsträger um jeweils eine äquidistante Strecke weiterbewegt hat. Der Betrag dieser Strecke entspricht der Seitenlänge eines Bildpunktes oder Vielfachen davon.

Aufeinanderfolgende Teilbilder überlagern sich teilweise. Die Teilbilder sind immer mit einem Abschnitt des aufzuzeichnenden Gesamtbildes deckungsgleich.

Die Aufzeichnung erfolgt mittels einer Licht-Steuer-Einheit , vorzugsweise einem Kippspiegel-Elemente-Halbleiter-Chip, mit matrixartig angeordneten Licht-Steuer-Elementen. Die Lichtsteuer-Einheit wird für die Aufzeichnung jedes Teilbildes computerprogrammgesteuert mit einem entsprechenden Steuermuster geladen. Bei Blitzbelichtung der Licht-Steuer-Einheit leitet - wenn das Steuermuster es so vorsieht-jedes Licht-Steuer-Element einen Lichtstrahl auf die ihm zugeordnete Bildpunkt-Rasterposition des Aufzeichnungsträgers zur Erzeugung eines Bildpunktes.

Diese Bildaufzeichnung dient insbesondere der Erstellung fotographischer Vorlagen für gedruckte Leiterplatten, der Direktbelichtung von Leiterplattenmaterial u.ä. und der Erstellung dreidimensionaler Strukturen für optische Elemente. Die Auflösung einer derartigen Bildaufzeichnung ist auf die Größe eines Bildpunktes begrenzt.

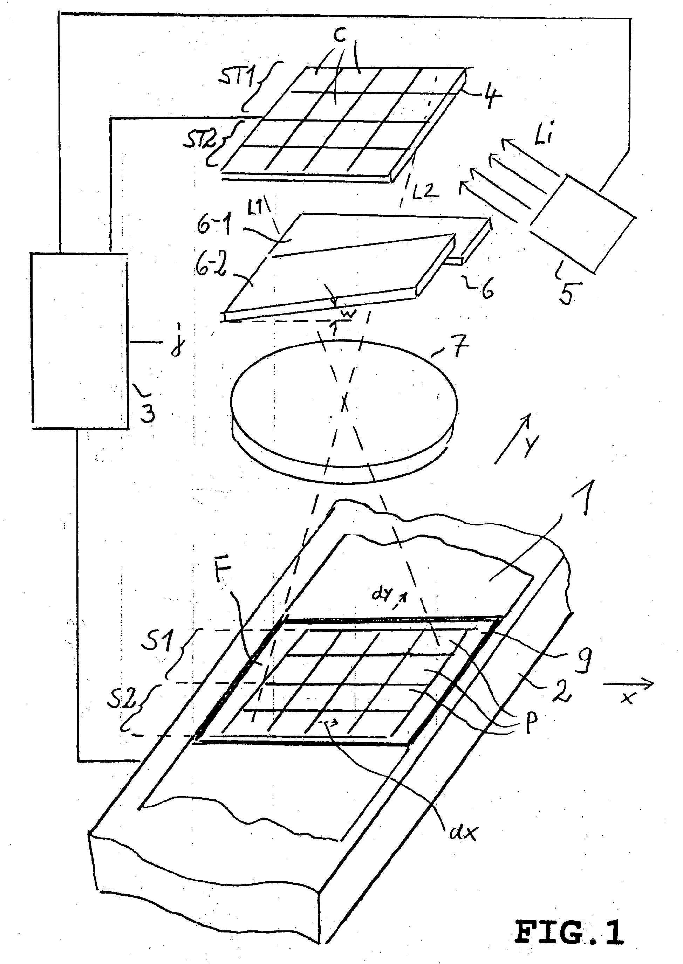

In der Patentschrift US 5 995 129 ist eine Anordnung beschrieben zur Aufzeichnung eines computergespeicherten Rasterbildes auf einen ebenen lichtempfindlichen Aufzeichnungsträger als ein aus Bildpunkten bestehendes Rasterbild in x/y Koordinatenrichtung, mit einer Licht-Steuer-Einheit( 12 in FIG.1; Spalte 4, Zeile 5) und einer Verschiebe-Einheit (19; Spalte 5, Zeile 34) für die Verschiebung des Aufzeichnungsträgers in y-Richtung.

Diese Anordnung weist folgende Merkmale auf:

Das Rasterbild ist mittels Belichtung einer mit Steuermustern per Computerprogramm beaufschlagbaren Licht-Steuer-Einheit erzeugbar (Spalte 5, Zeilen 9-11).

Die Licht-Steuer-Einheit (12) besteht aus matrixartig angeordneten Licht-Steuer-Elementen (Spalte 4, Zeile 51).

Ein Lichtpunkt ist durch von einem Licht-Steuer-Element leitbaren Lichtstrahl an einer ihm zugeordneten Position des Rasterbildes aufzeichenbar.

Der Aufzeichnungsträger ist gegenüber der Licht-Steuer-Einheit (oder umgekehrt) verschiebbar (19), wobei der Abstand der Ebenen, in welchen der Aufzeichnungsträger und die Licht-Steuer-Einheit liegen, gleich bleibt.

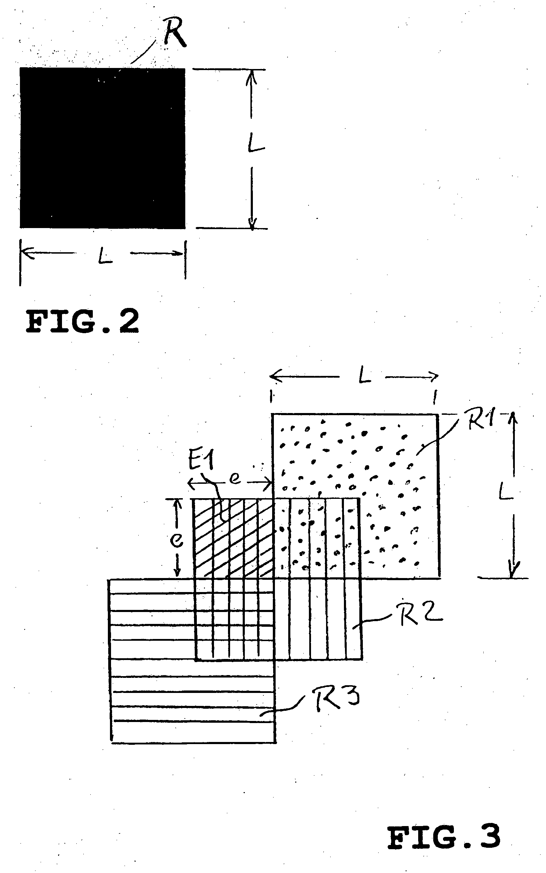

Für Belichtungszeitpunkte ist jeweils ein Steuermuster in die Licht-Steuer-Einheit (12) ladbar für die Aufzeichnung eines Teilbildes in der Belichtungsstation (siehe FIG.3A-3B), welches vom Steuermuster ableitbar ist.

Die Belichtungsstation nimmt immer die gleiche Position bezüglich der Licht-Steuer-Einheit ein.

Die Aufzeichnung aller Bildpunkte eines Teilbildes (1,2,3,4,...; FIG. 3A-3D; Spalte 6, Zeilen 16-55) erfolgt gleichzeitig.

Der Aufzeichnungsträger ist zwischen zwei aufeinanderfolgenden Belichtungszeitpunkten in y-Richtung um eine äquidistante y-Verschiebestrecke verschiebbar, wobei ein aufgezeichnetes Teilbild ein nachfolgend aufgezeichnetes Teilbild teilweise überlagert (FIG.3A-3D). Jedes aufgezeichnete Teilbild ist mit einem Teil des gedachten aufzuzeichnenden Rasterbildes auf dem Aufzeichnungsträger deckungsgleich.

Die y-Verschiebe-Strecke hat einen Wert, welcher einen Bruchteil der Länge einer Seite eines Bildpunktes einschließt (FIG.3A-3D).

Zwischen der Licht-Steuer-Einheit (12) und dem Aufzeichnungsträger (14) ist eine Anordnung (17) zum Versatz bildpunkterzeugender Lichtstrahlen in x-Richtung angeordnet, wobei die x-Versatzstrecke einem Bruchteil der Länge einer Seite eines Bildpunktes beträgt und der Maximalwert einer x-Versatzstrecke kleiner ist als die Länge der Seite eines Bildpunktes (siehe FIG.3A-3D; Spalte 6, Zeilen 16-55).

Der wesentliche Unterschied zwischen dem Gegenstand gemäß der vorgenannten Patentschrift US 5 005 129 und dem Gegenstand gemäß der vorliegenden Anmeldung liegt darin,

daß gemäß der vorgenannten Patentschrift US 5 005 129 das "plane-parallel plate 17" (mechanisch) in seiner Winkelstellung variiert wird, während bei der vorliegenden Anmeldung die einzelnen Glasstreifen 6-1, 6-2 bzw. 6-1*, 6-2*, 6-3* und 6-4* der optischen Licht-Auslenk-Einheit 6* feste Winkelpositionen einnehmen.

Die (mechanische) Verstellung der Winkelstellung gemäß der Patentschrift US 5 005 129 bedingt eine "Wartezeit" zwischen einer Einstellung und einer nachfolgenden wegen unerwünschter aber immer in Kauf zu nehmender Bewegungen (Beschleunigungen oder Verzögerungen) der Verstellmechanik während der Verstellung. Das Einstellen der Winkelstellungen gemäß US 5 005 129 erfolgt quasi im "START / STOP"-Betrieb. Die damit verbundenen Wartezeiten wirken sich nachteilig auf die Datenverarbeitungsgeschwindigkeit aus, so daß eine Aufzeichnung länger dauert (als bei der vorliegenden Ammeldung). Desweiteren ist bei der Anordnung gemäß US 5 005 129 eine weitere Erhöhung der horizontalen Auflösung nicht möglich.

Es ist deshalb Aufgabe der Erfindung, ein Fotoplott-Verfahren und eine Anordnung zu seiner Durchführung anzugeben für eine erhöhte Bildaufzeichnung und eine erhöhte Bildauflösung.

Diese Aufgabe der Erfindung wird durch die im kennzeichnenden Teil der Ansprüche 1 bzw.19 angebenen Merkmale gelöst. Vorteilhafte Weiterbildungen der Erfindung sind in den Unteransprüche gekennzeichnet.

Beim Gegenstand der vorliegenden Anmeldung ist eine Vervielfachung der horizontalen Auflösung gegeben in Abhängigkeit von der Anzahl der Streifenbereiche.

Das Ausführungsbeispiel mit zwei Streifenbereichen ergibt eine Verdopplung der horizontalen Auflösung; das Ausführungsbeispiel mit vier Streifenbereichen eine Vervierfachung.

Eine solche Möglichkeit ist durch die Anordnung gemäß US 5 995 129 nicht beschrieben und auch nicht nahegelegt.

Die sich beim Gegenstand der vorliegenden Anmeldung bei Vervielfachung der horizontalen Auflösung ergebende Überlagerung von Belichtungsenergie ermöglicht eine wirksame Belichtung weniger lichtempfindlicher Aufzeichnungsträger. Für den Fall, daß pro Belichtungsvorgang nur ein relativ "schwacher Belichtungsblitz" verfügbar ist, der keine ausreichende Belichtung bewirken kann, kann dies durch überlagernde Mehrfachbelichtung ausgeglichen werden.

Beim Gegenstand gemäß US 5 995 129 wird während der Winkelverstellung des "plane-parallel plate 17" die Belichtung immer unterbrochen; beim Gegenstand der vorliegenden Anmaldung erfolgt die Belichtung je nach Erfordernis entweder im Dauerlicht- oder im Pulsbetrieb. Beim Dauerlicht-Betrieb geht im Gegensatz zum Pulsbetrieb (mit An- und Aus-Schaltung) keine Energie verloren.

Der Dauerlicht-Betrieb bedingt bei Verschiebungen des Aufzeichnungsträgers im Mikrometerbereich nur kleinste vernachlässigbare Unschärfen.

Bei vertikalen Sprüngen über mehrere pixel hinweg wäre jedoch ein Pulsbetrieb geboten, damit sich bei der Aufzeichnung kein unerwünschter "Schmier-Effekt" auswirkt.

Ausführungsbeispiele und Darstellungen zur Wirkungsweise. der Erfindung sind in den Zeichnungen dargestellt und werden im folgenden näher beschrieben. Es zeigen:

FIG.1
eine schematische Darstellung einer erfindungsgemäßen Anordnung zur Aufzeichnung eines computergespeicherten Rasterbildes auf einem ebenen lichtempfindlichen Aufzeichnungsträger;

FIG.2
eine schematische Darstellung eines aufgezeichneten Lichtpunktes;

FIG. 3
eine schematische Darstellung einander in x- und y-Richtung überlappender Bildpunkte;

FIG.4
eine schematische Darstellung eines Beispiels für ein Gesamtbild, welches mit einer aus 4x4 Licht-Steuer-Elementen bestehenden Licht-Steuer-Einheit aufgezeichnet wurde;

FIG.5A und FIG.5B

FIG.6A und FIG.6B

FIG.7A und FIG.7B

FIG.8A und FIG.8B

FIG.9A und FIG.9B

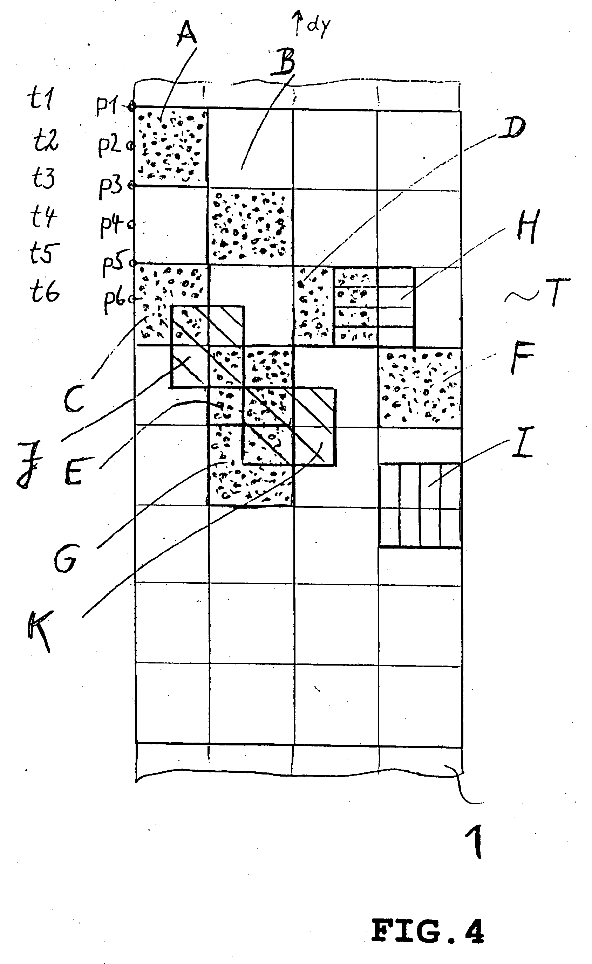

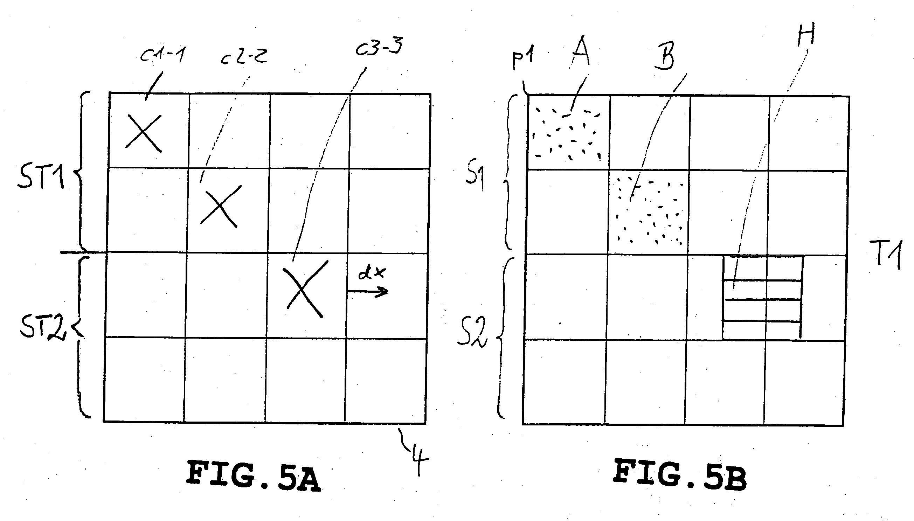

FIG.10A und FIG.10B
eine schematische "schrittweise" Darstellung der Bildauf-zeichnung für einen Teil des in FIG. 4 dargestellten Gesamtbildes, wobei in den FIG. 5A, 6A ,7A, 8A , 9A und 10A jeweils das Steuermuster für die Licht-Steuer-Einheit schematisch angegeben ist und in den FIG. 5B, 6B, 7B, 8B, 9B und 10B die aus den entsprechenden Steuermustern resultierenden aus Bildpunkten bestehenden Teilbilder;

FIG.11
eine schematische Darstellung des Snellius -Gesetzes der Optik zum Verlauf eines eine ebene Glasplatte schräg durchdringenden Lichtstrahles;

FIG.12
eine schematische Darstellung einer Licht-Steuer-Einheit aus 12x12 Licht-Steuer-Elementen, die in vier gedachte Streifenbereiche aufgeteilt ist,
in Verbindung mit der schematischen Darstellung einer optischen Einheit zum Versatz der Lichtstrahlen pro Streifenbereich.

FIG.13A
eine schematische Darstellung einer Licht-Steuer-Einheit mit 9x9 Licht-Steuer-Elementen, welche in 3 Streifenbereiche mit je 3 Reihen von Lichtsteuer-Elementen aufgeteilt ist.

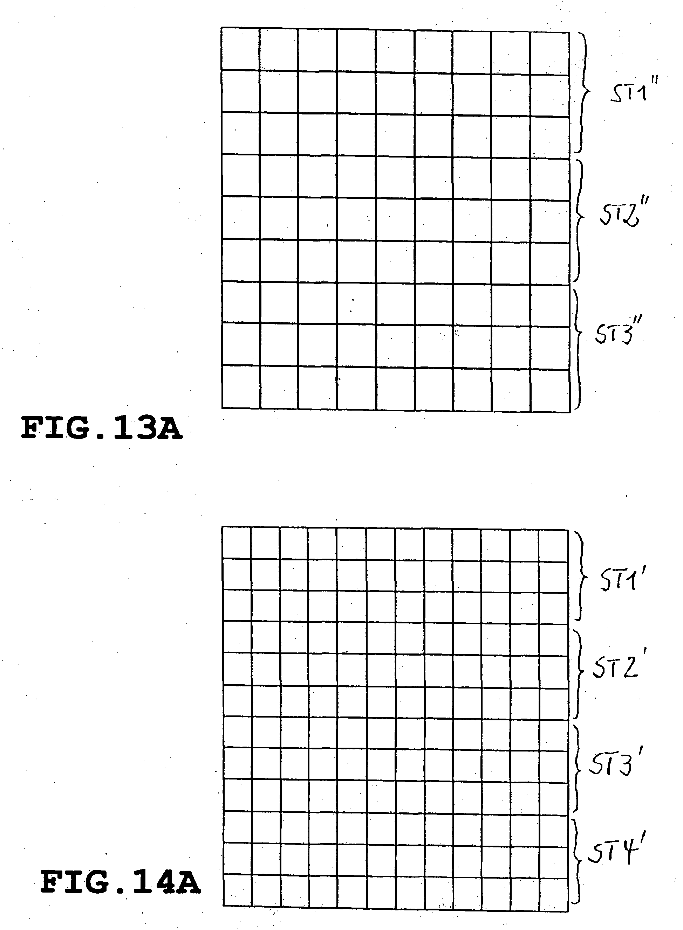

FIG. 13 B
die schematische Darstellung eines Aufzeichnungsträgers (in Analogie zu FIG.4) für die Aufzeichnung von Teilbildern unter Berücksichtigung der Aufteilung de Licht-Steuer-Einheit gemäß FIG. 14A für unterschiedliche jeweils äquidistante y-Verschiebestrecken.

FIG.14A
eine schematische Darstellung einer Licht-Steuer-Einheit mit 12x12 Licht-Steuer-Elementen, welche in 4 Streifenbereiche mit je 3 Reihen von Lichtsteuer-Elementen aufgeteilt ist.

FIG. 14B
die schematische Darstellung eines Aufzeichnungsträgers (in Analogie zu FIG.4) für die Aufzeichnung von Teilbildern unter Berücksichtigung der Aufteilung der Licht-Steuer-Einheit gemäß FIG. 14A für unterschiedliche jeweils äquidistante y-verschiebestrecken.

FIG.15
eine schematische Darstellung eines Aufzeichnungsträgers mit spaltenweiser Bildaufzeichnung;

FIG.16
eine Darstellung der Funktion der Aufzeichnungsstärke z für Bildpunkte in Abhängigkeit von ihrer Position entlang der Breite eines Teilbildes;

FIG.17
eine schematische Darstellung zweier sich teilweise überlagernder Streifen für die Bildaufzeichnung mit einem jeweils gauß-kurven-ähnlichem Verlauf der Aufzeichnungsstärke der Bildpunkte in Abhängigkeit von ihrer Position entlang der Streifenbreite.

FIG.1 zeigt
eine schematische Darstellung einer erfindungsgemäßen Anordnung zur Aufzeichnung eines computergespeicherten Rasterbildes auf einem ebenen lichtempfindlichen Aufzeichnungsträger 1.
Das auf den ebenen lichtempfindlichen Aufzeichnungsträger 1 in x/y-Koordinatenausrichtung aufzuzeichnende Rasterbild (s.FIG.4) ist codiert in einem Computer 3 gespeichert. Die Aufzeichnung des Rasterbildes erfolgt computerprogrammgesteuert.
Der Computer 3 ist über eine Steuerleitung mit einer Licht-Steuer-Einheit 4 verbunden.
Die Licht-Steuer-Einheit 4 wird zu bestimmten Zeitpunkten mit Licht Li - vorzugsweise mit gepulstem Licht - beaufschlagt. Dieses wird in einer Licht-Einheit 5 erzeugt.
Der Computer 3 ist über eine Steuerleitung mit der Licht-Einheit 5 verbunden.

Die Licht-Steuer-Einheit 4 besteht aus einer Vielzahl matrixartig angeordneter Licht-Steuer-Elemente c .

Die Bildaufzeichnung erfolgt in einem Belichtungsflächenfeld F einer Belichtungsstation 9.

Die Belichtungsstation 9 nimmt zu allen Belichtungszeitpunkten immer die gleiche Position gegenüber der Licht-Steuer-Einheit 4 ein; das Belichtungsflächenfeld F ist in gedachte matrixartig angeordnete Bildpunkt-Rasterpositionen p aufgeteilt. Jede Bildpunkt-Rasterposition ist um einen Betrag , z.B. dx, der kleiner ist als die Seitenlänge eines Bildpunktes, in x-Richtung verschiebbar.

Die Bildpunkt-Rasterpositionen p des Belichtungsflächenfeldes F und die matrixartig angeordneten Licht-Steuer-Elemente c der Licht-Steuer-Einheit 4 entsprechen einander.

Jedes Licht-Steuer-Element ist einer Bildpunkt-Raster-Position des Belichtungsflächenfeldes F zugeordnet.

Der Aufzeichnungsträger 1 ist auf einer Verschiebeeinrichtung 2 (z.B. einem Transportschlitten) angeordnet, welcher in geradliniger Richtung y unter der Licht-Steuer-Einheit 4 mit kontinuierlicher Geschwindigkeit oder schrittweise bewegt wird. Die Ebene, in welcher der Aufzeichnungsträger 1 liegt, und die Ebene , in welcher die Licht-Steuer-Einheit 4 liegt, haben immer den gleichen Abstand.

Für jeden Belichtungszeitpunkt erhält die Licht-Steuer-Einheit 4 vom Computer ein Steuermuster für die Bildaufzeichnung im Belichtungsflächenfeld F der Belichtungsstation 9 programmgesteuert "mitgeteilt".

Zwischen den einzelnen Belichtungszeitpunkten wird der Aufzeichnungsträger in y-Richtung um einen äquidistanten Betrag dy weiterbewegt, welcher kleiner ist als die Seitenlänge L eines Bildpunktes R (s.FIG.2).

Durch das Steuermuster werden die Licht-Steuer-Elemente derart gesteuert, daß bei ihrer Beaufschlagung mit Licht jedes Licht-Steuer-Element einen Lichtstrahl auf die ihm zugeordnete Bildpunkt-Raster-Position des Belichtungsflächenfeldes F richtet oder nicht. Ein auf eine Bildpunkt-Raster-Position auftreffender Lichtstrahl bewirkt die Aufzeichnung eines Bildpunktes ; ein nicht auftreffender Lichtstrahl bewirkt keine Bildpunktaufzeichnung.

Die Aufzeichnung eines Bildes im Belichtungsflächenfeldes F erfolgt gleichzeitig für alle Bildpunktpositionen.

Es handelt sich dabei um die Aufzeichnung eines Teilbildes; das Gesamtbild (FIG.4) wird aus mehreren sich teilweise überlagernden Teilbildern zusammengesetzt.Diese Teilbilder erscheinen auf dem Aufzeichnungsträger in y-Richtung an gegeneinander verschobenen Positionen.

Zwischen dem Aufzeichnungsträger 1 und der Licht-Steuer-Einheit 4 ist ein den Abbildungsmaßstab bestimmendes Objektiv 7 angeordnet. Die Aufzeichnung der Bildpunkte - bezogen auf die ihnen entsprechenden Licht-Steuer-Elemente- erfolgt seiten- und höhenverkehrt, wie beispielsweise durch die Lichtstrahlen 11 und 12 angedeutet.

Der Computer 3 ist über eine Steuerleitung mit der Verschiebe-Einrichtung 2 zur Erfassung der aktuellen Verschiebeposition verbunden.

Über eine andere Steuerleitung j erhält der Computer 3 die Daten für das aufzuzeichnende Rasterbild mitgeteilt.

Die Licht-Steuer-Einheit ist in gedachte Streifenbereiche ST1, ST 2 aufgeteilt.

Wenn die Licht-Steuer-Einheit z.B. ein Kippspiegel-Elemente-Halbleiter-Chip ist, werden die auf die Streifenbereiche ST1 und ST2 auftreffenden Lichtstrahlen Li von den Kippspiegelelementen reflektiert.

Vor ihrem Auftreffen auf den Aufzeichnungsträger zur Aufzeichnung der Bildpunkte durchlaufen sie eine optische Auslenkeinheit.

Diese besteht aus einem ebenen Glasstreifen 6-1 für den Streifenbereich ST1 und einen ebenen Glasstreifen 6-2 für den Streifenbereich ST2.

Beide Glasstreifen haben die gleiche Dicke sind aber unterschiedlich gegenüber den ihnen zugeordneten Streifenbereichen angeordnet.

Der Glasstreifen 6-1 ist parallel zur Ebene der Licht-Steuer-Einheit 4 und parallel zur Ebene des Aufzeichnungsträgers 1 angeordnet. Er bewirkt keine optische Auslenkung der ihn passierenden Lichtstrahlen. Die auf den Streifenbereich ST1 auftreffenden Lichtstrahlen werden von den Kippspiegel-Elementen dieses Bereiches reflektiert. Sie passieren den Glasstreifen 6-1 ohne Veränderung ihrer Richtung und treffen dann auf den Aufzeichnungsträger.

Der Glasstreifen 6-2 ist gegenüber einer Ebene, die parallel zur Ebene der Licht-Steuer-Einheit 4 und parallel zur Ebene des Aufzeichnungsträgers 1 verläuft, schräg angeordnet. Der Anstiegswinkel ist mit w gekennzeichnet.

Die auf den Streifenbereich ST2 auftreffenden Lichtstrahlen werden ebenfalls von den Kippspiegelelementen dieses Streifenbereiches reflektiert ; vor ihrem Auftreffen auf den Aufzeichnungsträger 1 durchlaufen sie den Glasstreifen 6-2 und werden dabei in x-Richtung versetzt. Durch diesen Versatz werden auf dem Aufzeichnungsträger im Streifenbereich S2, der dem Streifenbereich ST2 der Licht-Steuer-Einheit 4 zugeordnet ist, versetzte Bildpunkte aufgezeichnet. Diese aufgezeichneten Bildpunkte erscheinen gegenüber gedachten durch unversetzte Lichtstrahlen aufgezeichgezeichnete Lichtpunkte z.B. um die x Versatzstrecke dx in x-Richtung verschoben.

Der Glasstreifen 6-1 erfüllt den Zweck, daß zwischen den Lichtstrahlen, die den Glasstreifen 6-1 passieren und den Lichtstrahlen, die den Glasstreifen 6-2 passieren, keine störenden Laufzeitunterschiede auftreten.

In einem aufgezeichneten aus mehreren Teilbildern bestehenden Gesamtbild kann

a) ein unversetzt aufgezeichneter Bildpunkte mit einem in x-Richtung versetzt aufgezeichneten Bildpunkt überlappen,

b) ein unversetzt aufgezeichneter Bildpunkt eines Teilbildes mit einem Bildpunkt eines nachfolgend aufgezeichneten Teilbildes in y-Richtung überlappen, da zwischen zwei aufeinanderfolgenden Belichtungszeitpunkten zur Aufzeichnung von Teilbildern der Aufzeichnungsträger um einen entsprechenden Betrag in y-Richtung verschoben wurde. Die y-Verschiebestrecke ist kleiner als die Länge der Seite eines Bildpunktes.

Durch solche Bildpunkt-überlappungen ergeben sich gedachte kleine Bild-Elemete E1 (FIG.3). Diese Bild-Elemente E1 sind kleiner als die Bildpunkte R1, R2 bzw. R3.

Im Falle der Aufteilung der Licht-Steuer-Einheit in 2 Streifenbereiche würde der Bildpunktversatz dx in x-Richtung 1/2 (die Hälfte) der Länge einer Bildpunktseite betragen ; beträgt der Vorschub dy des Aufzeichnungsträgers in y-Richtung von Belichtungszeitpunkt zu Belichtungszeitpunkt ebenfalls 1/2 (die Hälfte) der Länge einer Bildpunktseite, ergeben sich bei der Bildaufzeichnung durch Überlagerung überlappender Bildpunkte gedachte ( quadratische ) kleine Bildelemente E1, deren Seitenlänge 1/2 (die Hälfte) der Länge einer Bildpunktseite beträgt; d.h. die Auflösung des aufgezeichneten Gesamtbildes hätte sich in x- und in y-Richtung verdoppelt, da nunmehr das Gesamtbild aus kleineren Bildelementen (und nicht aus größeren Bildpunkten) zusammengesetzt scheint.

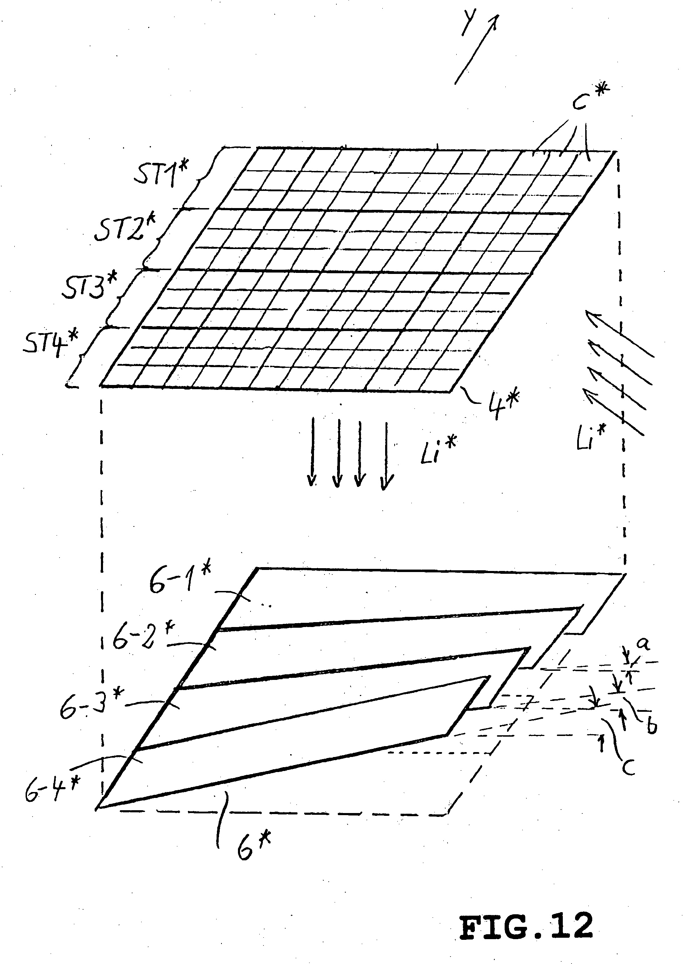

Eine weitere Steigerung der Auflösung eines Gesamtbildes wird dadurch erreicht, daß bei der Bildaufzeichnung die Licht-Steuer-Einheit in noch mehr ( mehr als 2 ) Streifenbereiche, z.B. gemäß der Darstellung in FIG. 12 aufgeteilt wird. In diesem Zusammenhang ist eine daran angepaßte Licht-Auslenk-Einheit erforderlich, die für jeden Streifenbereich einen anderen Versatz der aufzuzeichnenden Lichtpunkte in x-Richtung bedingt. Bei einer Aufteilung in vier Streifenbereiche, werden

a) die vom ersten Streifenbereich ST1* ausgehenden Lichtstrahlen zur Aufzeichnung der Lichtpunkte nicht versetzt,
b) die vom zweiten Streifenbereich ST2* ausgehenden Lichtstrahlen zur Aufzeichnung der Lichtpunkte um den Betrag ¼ der Länge einer Bildpunktseite versetzt,
c) die vom dritten Streifenbereich ST3* ausgehenden Lichtstrahlen zur Aufzeichnung der Lichtpunkte um den Betrag $2 \times$ ¼ der Länge einer Bildpunktseite versetzt werden und
d) die vom vierten Streifenbereich ST4* ausgehenden Lichtstrahlen zur Aufzeichnung der Lichtpunkte um den Betrag $3 \times$ ¼ der Länge einer Bildpunktseite versetzt.

Bei einer y-Verschiebestrecke des Aufzeichnungsträgers von ¼ der Länge der Seite eines Bildpunktes zwischen zwei aufeinanderfolgenden Belichtungszeitpunkten ergeben sich durch Bildpunktüberlappung kleine gedachte quadratische Bildelemente der mit der Seitenlänge von ¼ einer Bildpunktseite, d.h. die Auflösung eines aufgezeichneten Bildes würde sich in x- und in der y-Richtung vervierfachen ( bezogen auf ein Bild, daß aus Bildpunkten besteht, welche sich nicht überlappen).

FIG.2 zeigt
eine schematische Darstellung eines aufgezeichneten Bildpunktes

Bei idealer Betrachtung hat der Bildpunkt R ein quadratische Form mit einer Seitenlänge von L.

Bei modernen Fotoplottern beträgt die Seitenlänge eines Bildpunktes ca. 10 - 15 Mikrometer.

Die Erfindung schließt alle Formen von Bildpunkten ein, auch wenn sie nur an Hand quadratischer Bildpunkte erklärt wird. Abweichend von einem Quadrat geformte Bildpunkte würden für das erfindungsgemäße Verfahren eine entsprechend weitergehende mathematische Berechnung bedingen.

Aus Übersichtsgründen werden in den Figuren Bildpunkte auch schraffiert oder gepunktet dargestellt.

FIG. 3 zeigt
eine schematische Darstellung einander in x- und y-Richtung überlappender Bildpunkte R1 (gepunktet), R2 (vertikal schraffiert) und R3 (horizontal schraffiert). Alle Bildpunkte haben die Seitenlänge L. Im dargestellten Beispiel überlappen sie in x- bzw. y-Richtung um den Betrag einer halben Seitenlänge L/2

Durch die Überlappung entsteht zum Beispiel ein gedachtes kleines quadratisches Bildelement E1 mit der Seitenlänge e = L/2. Dieses Bildelement E1 ist kleiner als ein Bildpunkt. Bei der dargestellten Bildpunkt-Überlappung ergibt sich deshalb eine Verdoppelung des Auflösungsvermögens sowohl in x-als auch in y-Richtung.

Eine weitere Erhöhung des Auflösungsvermögens wird in Zusammenhang mit der Darstellung von FIG.12 beschrieben.

FIG.4 zeigt
eine schematische Darstellung eines Gesamtbildes T. Das Gesamtbild T ist aus mehreren Bildpunkten A, B, C, D, E, F, G, H und I zusammengesetzt.

Das Gesamtbild T in FIG. 4 ist durch ein Positions-Netz-Gitter strukturiert.

Das Gesamtbild T besteht aus Bildpunkten, die wie folgt angeordnet sein können:

a) der Bildpunkt füllt eine Netz-Gitter-Position

- wie z.B. die Bildpunkte A, B, C, D, E, F, G (gepunktete Darstellung)-

b) der Bildpunkt - wie z.B. Bildpunkt H (horizontal schraffiert) - ist in x-Richtung

- bezogen auf eine Netzgitter-Position - um eine x-Versatzstrecke versetzt ( im Beispiel gemäß FIG. 4 beträgt die x-Versatzstrecke dx= ½ der Bildpunkt-Seitenlänge

c) der Bildpunkt - wie z.B. Bildpunkt I (vertikal schraffiert)-ist in y-Richtung -bezogen auf eine Netzgitter-Position - um eine y-Verschiebestrecke versetzt ( im Beispiel gemäß FIG. 4 beträgt die y- Verschiebestrecke dy= ½ der Bildpunkt-Seitenlänge; damit ist dy= dx.
Die y-Verschiebestrecke resultiert aus dem Vorschub des Aufzeichnungsträgers zwischen zwei Belichtungszeitpunkten.

d) der Bildpunkt - wie z.B. die Bildpunkte J und K (schräge Schraffur) - sind sowohl in x-Richtung als auch.in y-Richtung -bezogen auf eine Netzgitter-Position - um dx versetzt bzw. um dy verschoben.

Das Gesamtbild T ist codiert im Computer gespeichert, von diesen gespeicherten Daten wird für jeden Belichtungszeitpunkt t1, t2, t3, t4, ...das Steuermuster für die Licht-Steuer-Einheit zur Erzeugung von Teilbildern abgeleitet. Zu jedem Belichtungszeitpunkt wird ein Teilbild (in der Belichtungsstation 9 (FIG.1) aufgezeichnet.

Zwischen zwei aufeinanderfolgenden Belichtungszeitpunkten wird der. Aufzeichnungsträger um dy= ½ Bildpunkt-Seitenlänge in y-Richtung vorgeschoben.

Die auf den Aufzeichnungsträger aufgezeichneten Teilbilder überlappen sich teilweise. Aus der Überlagerung aller Teilbilder ergibt sich das Gesamtbild T.

Die
FIG.5A und FIG.5B,
FIG.6A und FIG.6B,
FIG.7A und FIG.7B
FIG.8A und FIG.8B
FIG.9A und FIG.9B
FIG.10A und FIG.10B

zeigen
eine schematische "schrittweise" Darstellung der Bildaufzeichnung für das in FIG.4 dargestellte Gesamtbild T, wobei in den FIG.5A, 6A, 7A, 8A, 9A, und 10A jeweils das Steuermuster für die Licht-Steuer-Einheit schematisch dargestellt werden und in den FIG. 5A, 6B, 7B, 8B, 9B, und 11B die aus den entsprechenden Steuermustern resultierenden aus Bildpunkten bestehenden Teilbilder T1 bis T6. Ein Teil des in FIG.4 dargestellten Gesamtbildes T wird in folgenden ("Scrolling"-)Schritten erzeugt:

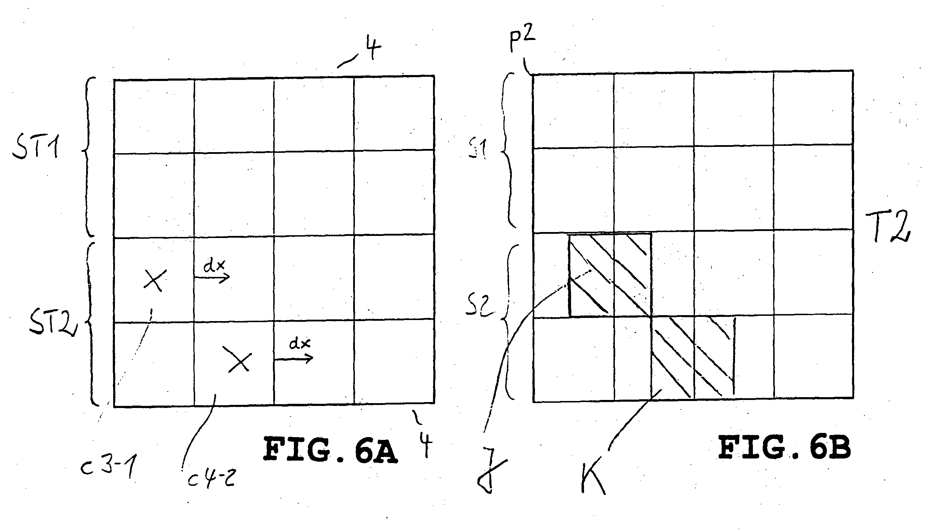

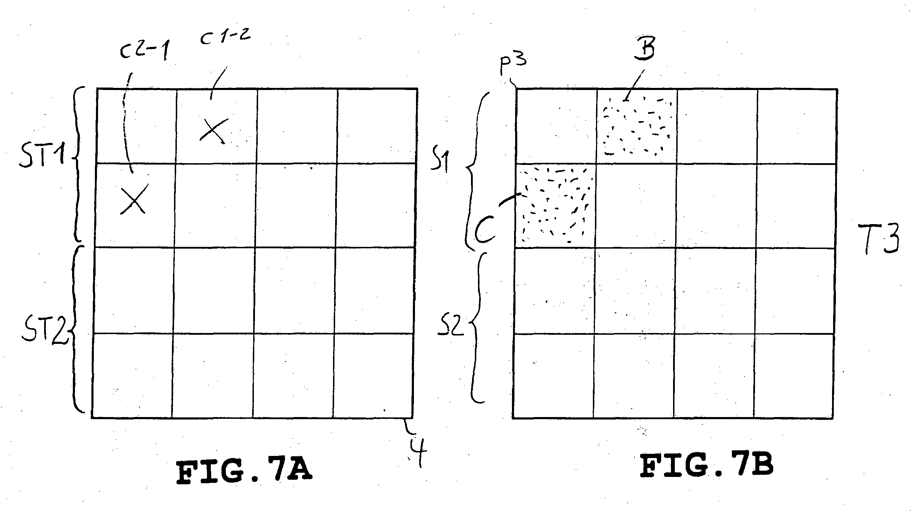

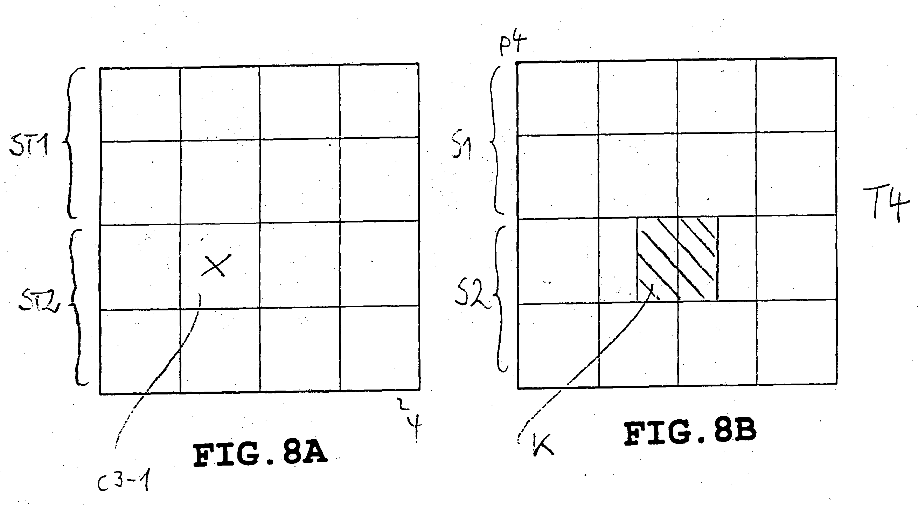

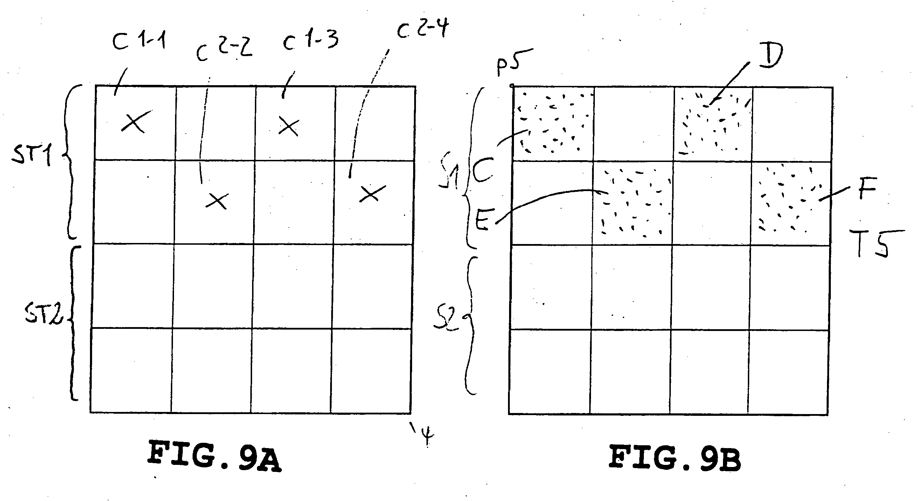

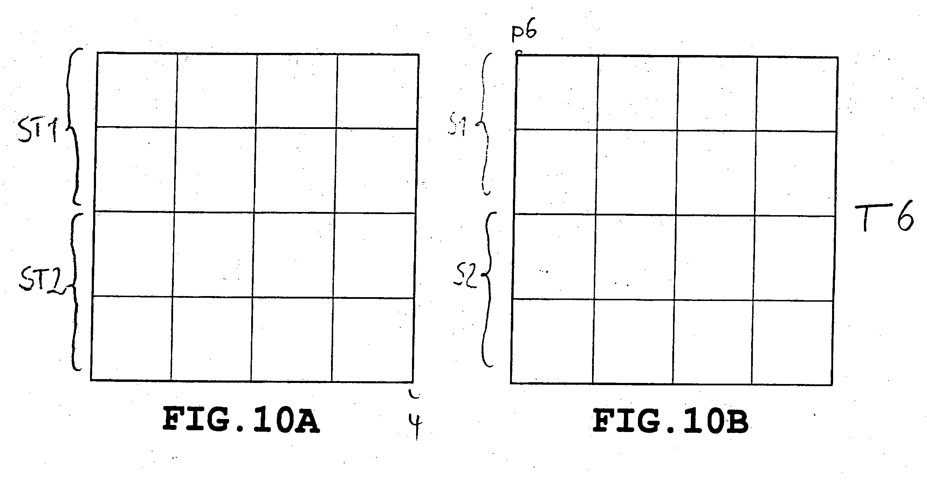

Belichtungszeitpunkt t1 : Aufzeichnung des Teilbildes T1 (s. FIG.5A und FIG.5B )
Belichtungszeitpunkt t2 : Aufzeichnung des Teilbildes T2 (s. FIG. 6A und FIG.6B)
Belichtungszeitpunkt t3 : Aufzeichnung des Teilbildes T3 (s. FIG. 7A und FIG.7B)
Belichtungszeitpunkt t4 : Aufzeichnung des Teilbildes T4 (s. FIG. 8A und FIG.8B)
Belichtungszeitpunkt t5 : Aufzeichnung des Teilbildes T5 (s. FIG. 9A und FIG.9B)
Belichtungszeitpunkt t6 : Aufzeichnung des Teilbildes T6 (s. FIG. 10A und FIG.10B)

Die Teilbilder T1, T2, T3, T4, werden so auf dem Aufzeichnungsträger platziert,
daß die obere linke Ecke p1 des Teilbildes T1 (FIG.5B) mit der Position p1 auf dem Aufzeichnungsträger 1 in FIG.4 übereinstimmt,
daß die obere linke Ecke p2 des Teilbildes T2 (FIG.6B) mit der Position p2 auf dem Aufzeichnungsträger 1 in FIG.4 übereinstimmt,
daß die obere linke Ecke p3 des Teilbildes T3 (FIG.7B) mit der Position p3 auf dem Aufzeichnungsträger 1 in FIG.4 übereinstimmt, usw.

Die Teilbilder sind jeweils um den Betrag dy= ½ Bildpunkt-Seitenlänge in y-Richtung verschoben.

Diese dy Verschiebung der Teilbilder resultiert daraus, daß der die Belichtungsstation passierende Aufzeichnungsträger zwischen aufeinanderfolgenden Belichtungszeitpunkten um den Betrag dy in y-Richtung verschoben wird.

Für das in FIG.5 dargestellte Beispiel ist dy = dx mit der Größe einer halben Bildpunkt-Seitenlänge.

Da das Netz-Gitter für das Gesamtbild T (FIG.5) eine Breite für 4 Netz-Gitter-Positionen hat, muß die zugehörige Licht-Steuer-Einheit 4 aus 4x4 Licht-Steuer-Elementen bestehen.

Den 4x4 Licht-Steuer-Elementen der Licht-Steuer-Einheit sind die 4x4 Bildpunkt-Positionen eines Teilbildes zugeordnet. Das Teilbild ist - wie auch das Gesamtbild- mit einem Positions-Netzgitter zur Kennzeichnung der Bildpunkt-Positionen strukturiert.

In einem Teilbild aufgezeichnete Bildpunkte können wie folgt angeordnet sein:

a) der Bildpunkt füllt eine Netz-Gitter-Position

- wie z.B. die Bildpunkte A und B, etc.
  oder

b) der Bildpunkt - wie z.B. Bildpunkt H- ist in x-Richtung

- bezogen auf eine Netzgitter-Position - um eine x-Versatzstrecke versetzt ( im Beispiel gemäß FIG. 4 und FIG.5B beträgt die x-Versatzstrecke ½ der Bildpunkt-Seitenlänge und ist mit dx bezeichnet.

Die Anordnung der Bildpunkte gemäß Punkt a) oder gemäß Punkt b) erfolgt in bestimmten Bereichen des Teilbildes, die entsprechenden Bereichen der Licht-Steuer-Einheit entsprechen. Für das vorliegende Beispiel (Licht-Steuer-Einheit, die aus 4x4 Licht-Steuer-Elementen besteht; x-Versatzstrecke dx= ½ der Bildpunkt-Seitenlänge ( wichtig in diesem Zusdammenhang ist der Nenner 2 bei ½ ) ist die Licht-Steuer-Einheit ist in 2 gedachte untereinanderliegende Streifenbereiche ST1 und ST2 aufgeteilt. Jeder Streifenbereich ist gleich groß und umfaßt die gleiche Anzahl von in je 2 Reihen angeordneten Licht-Steuer-Elementen. Dem Streifenbereich ST1 der Licht-Steuer-Einheit ist der Bereich S1 des Teilbildes; dem Streifenbereich ST2 der Licht-Steuer-Einheit ist der Bereich S2 des Teilbildes zugeordnet. Die y-Verschiebestrecke ist gleich der x-Versatzstrecke.
Für die Aufzeichnung des Teilbildes gilt:

- Durch die Licht-Steuer-Elemente des Streifenbereiches ST1 der Licht-Steuer-Einheit werden Bildpunkte im Bereich S1 des Teilbildes an Netz-Gitter-Positionen aufgezeichnet. Diese Bildpunkte "passen" genau in die durch das Netz-Gitter vorgegebenen Positionsfelder.

- Durch die Licht-Steuer-Elemente des Streifenbereiches ST2 der Licht-Steuer-Einheit werden Bildpunkte im Bereich S2 des Teilbildes an Positionen aufgezeichnet, die nicht mit den Netz-Gitter-Positionen übereinstimmen und diesen gegenüber in x-Richtung um die x-Versatzstrecke ( hier dx= ½ der Bildpunkt-Seitenlänge) versetzt sind.

Der x-Versatz der Bildpunkte wird wie folgt bewirkt: die von entsprechenden Licht-Steuer-Elementen ausgehenden Lichtstrahlen zur Aufzeichnung von Bildpunkten werden vor ihrem Auftreffen auf den Aufzeichnungsträger optisch in x-Richtung versetzt. Durch diese versetzten Lichtstrahlen werden dann versetzte Bildpunkte aufgezeichnet.
(Es sei nochmals bemerkt, daß -wie in FIG. 12 dargestellt- eine Licht-Steuer-Einheit auch eine andere Streifenaufteilung erfahren kann. Für die Aufzeichnung eines Gesamtbildes mit einer Breite von beispielsweise 12 Netz-Gitter-Positionen wäre eine Licht-Steuer-Einheit mit 12 x12 Licht-Steuer-Elementen erforderlich. Diese kann z.B. in 4 gedachte Streifenbereiche mit je 3 Reihen von Licht-Steuer-Elementen aufgeteilt werden, wobei

- durch die Licht-Steuer-Elemente des Streifenbereiches ST1 der Licht-Steuer-Einheit Bildpunkte im Bereich S1 des Teilbildes an Netz-Gitter-Positionen aufgezeichnet werden. Diese Bildpunkte "passen" genau in die durch das Netz-Gitter vorgegebenen Positionsfelder;
- durch die Licht-Steuer-Elemente des Streifenbereiches ST2* der Licht-Steuer-Einheit Bildpunkte im Bereich S2* des Teilbildes an Positionen aufgezeichnet werden, die nicht mit den Netz-Gitter-Positionen übereinstimmen und diesen gegenüber in x-Richtung um die x-Versatzstrecke 1/4 der Bildpunkt-Seitenlänge versetzt sind;
- durch die Licht-Steuer-Elemente des Streifenbereiches ST3* der Licht-Steuer-Einheit Bildpunkte im Bereich S3* des Teilbildes an Positionen aufgezeichnet werden, die nicht mit den Netz-Gitter-Positionen übereinstimmen und diesen gegenüber in x-Richtung um die x-Versatzstrecke 2x1/4 der Bildpunkt-Seitenlänge versetzt sind;
- durch die Licht-Steuer-Elemente des Streifenbereiches ST4* der Licht-Steuer-Einheit Bildpunkte im Bereich S4* des Teilbildes an Positionen aufgezeichnet werden, die nicht mit den Netz-Gitter-Positionen übereinstimmen und diesen gegenüber in x-Richtung um die x-Versatzstrecke 3x1/4 der Bildpunkt-Seitenlänge versetzt sind.

In Kenntnis des Prinzips der Bildaufzeichnung ist es nunmehr einfach, die Darstellung der Steuermuster und der Teilbilder in den FIG. 5A und 5B bis 10A und 10B in Verbindung mit dem Gesamtbild T in FIG. 4 zu überprüfen.
Hierbei kann folgendermaßen vorgegangen werden:

Dabei stelle man sich vor, die Teilbilder seien auf Transparentpapier gezeichnet und würden nacheinander bezüglich des Positions-Netz-Gitters deckungsgleich auf das Gesamtbild gelegt werden, wobei jeweils die p1, p2, p3, .... Punkte der Teilbilder mit denen des Gesamtbildes T fluchten müssen.

Für das Teilbild T1 stellt man fest, welche Bildpunkte des Gesamtbildes in das Positionsraster von S1 fallen:

es handelt sich dabei um die Bildpunkte A und B.

Dann stellt man fest, ob und welche Bildpunkte des Gesamtbildes , die in x-Richtung um den Betrag dx versetzt sind, in den Bereich S2 fallen : es handelt sich in diesem Fall um den Bildpunkt H.

In Kenntnis der zuvor erläuterten Prinzips wird geprüft

a) ob für die im Teilbild T1 aufzuzeichnenden Bildpunkte A und B im Bereich ST1 der Licht-Steuer-Einheit 4 ( ST1 ist dem Bereich S1 des Teilbildes T1 zugeordnet) auch die entsprechenden Licht-Steuer-Elemente ( in diesem Fall c 1-1 und c2-2 ) zur Aufzeichnung der Bildpunkte A und B aktiviert sind.

b) ob für den im Teilbild T1 aufzuzeichnenden Bildpunkte H Bereich ST2 der Licht-Steuer-Einheit 4 ( ST2 ist dem Bereich S2 des Teilbildes T1 zugeordnet) auch das entsprechende Licht-Steuer-Elemente ( in diesem Fall c 3-3 ) zur Aufzeichnung des zu versetzenden Bildpunktes H aktiviert ist.

Für das Teilbild T2 stellt man fest, welche Bildpunkte des Gesamtbildes in das Positionsraster von S1 fallen: nämlich keine.

Dann stellt man fest, ob und welche Bildpunkte des Gesamtbildes , die in x-Richtung um den Betrag dx versetzt sind, in den Bereich S2 fallen : es handelt sich in diesem Fall um die Bildpunkte J und K.

In Kenntnis des zuvor erläuterten Prinzips wird geprüft

b) ob für den im Teilbild T2 aufzuzeichnenden Bildpunkte J und K im Bereich ST2 der Licht-Steuer-Einheit 4 ( ST2 ist dem Bereich S2 des Teilbildes T2 zugeordnet) auch die entsprechenden Licht-Steuer-Elemente ( in diesem Fall c3-1 und c4-2) zur Aufzeichnung der zu versetzenden Bildpunkte J und K aktiviert ist.

Für das Teilbild T3 stellt man fest, ob und welche Bildpunkte des Gesamtbildes in das Positionsraster von S1 fallen: es handelt sich dabei um die Bildpunkte B und C.

Dann stellt man fest, ob und welche Bildpunkte des Gesamtbildes , die in x-Richtung um den Betrag dx versetzt sind, in den Bereich S2 fallen : keine .

In Kenntnis des zuvor erläuterten Prinzips wird geprüft

a) ob für die im Teilbild T§ aufzuzeichnenden Bildpunkte B und C im Bereich ST1 der Licht-Steuer-Einheit 4 ( ST1 ist dem Bereich S1 des Teilbildes T1 zugeordnet) auch die entsprechenden Licht-Steuer-Elemente ( in diesem Fall c1-2 und c2-1 ) zur Aufzeichnung der Bildpunkte B und C aktiviert sind.

Für das Teilbild T4 stellt man fest, ob und welche Bildpunkte des Gesamtbildes in das Positionsraster von S1 fallen: keine Dann stellt man fest, ob und welche Bildpunkte des Gesamtbildes , die in x-Richtung um den Betrag dx versetzt sind, in den Bereich S2 fallen : es handelt sich in diesem Fall um den Bildpunkt K.

In Kenntnis des zuvor erläuterten Prinzips wird geprüft

b) ob für den im Teilbild T4 aufzuzeichnenden Bildpunkt K im Bereich ST2 der Licht-Steuer-Einheit 4 ( ST2 ist dem Bereich S2 des Teilbildes T4 zugeordnet) auch das entsprechende Licht-Steuer-Element ( in diesem Fall c3-1) zur Aufzeichnung des zu versetzenden Bildpunktes K aktiviert ist.

Für das Teilbild T5 stellt man fest, welche Bildpunkte des Gesamtbildes in das Positionsraster von S1 fallen: es handelt sich dabei um die Bildpunkte C, D, E und F.

Dann stellt man fest, ob und welche Bildpunkte des Gesamtbildes , die in x-Richtung um den Betrag dx versetzt sind, in den Bereich S2 fallen : keine.

In Kenntnis des zuvor erläuterten Prinzips wird geprüft

a) ob für die im Teilbild T1 aufzuzeichnenden Bildpunkte C, D, E und F im Bereich ST1 der Licht-Steuer-Einheit 4 ( ST1 ist dem Bereich S1 des Teilbildes T1 zugeordnet) auch die entsprechenden Licht-Steuer-Elemente ( in diesem Fall c1-1, c1-3, c2-2 und c2-4) zur Aufzeichnung der Bildpunkte C, D, E und F aktiviert sind.

Für das Teilbild T6 stellt man fest, welche Bildpunkte des Gesamtbildes in das Positionsraster von S1 fallen: keine. Dann stellt man fest, ob und welche Bildpunkte des Gesamtbildes , die in x-Richtung um den Betrag dx versetzt sind, in den Bereich S2 fallen : keine.

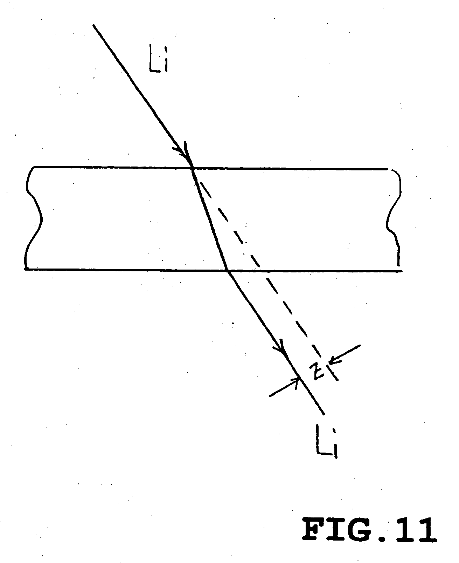

FIG.11 zeigt
eine schematische Darstellung des Snellius -Gesetzes der Optik zum Verlauf eines eine ebene Glasplatte G schräg durchdringenden Lichtstrahles Li, welcher (durch Lichtbrechung beim Eintritt in und beim Austritt aus der Glasplatte bedingt) um den Wert z versetzt aus der Glasplatte austritt.

Von dieser Gesetzmäßigkeit wird Gebrauch gemacht, um die Lichtstrahlen, welche von den Licht-Steuer-Elementen eines Streifenbereich der Licht-Steuer-Einheit zur Aufzeichnung von Lichtpunkten ausgehen, vor ihrem Auftreffen auf den Aufzeichnungsträger (in x-Richtung) zu versetzen.

FIG.12 zeigt

eine schematische Darstellung einer optischen Licht-Auslenk-Einheit 6 * zur Realisierung der Erfindung für eine aus 12 x 12 Licht-Steuer-Elementen bestehenden Licht-Steuer-Einheit 4*, welche in gedachte 4 Streifenbereiche ST1*, ST2*, ST3*, ST4* aufgeteilt ist.

Die optischen Licht-Auslenk-Einheit 6* zum Versatz bildpunkterzeugender Lichtstrahlen besteht aus gleichdicken ebenen Glasplatten 6-1*, 6-2*, 6-3* und 6-4*.

Die Licht-Steuer-Einheit 4* ( hier ein Kippspiegel-Elemente-Halbleiter-Chip) ist in mehrere untereinanderliegende Streifenbereiche ST1*, ST2*,ST3*, ST4* aufgeteilt.

Jedem Streifenbereich ST1*, ST2*, ST3*, ST4* ist eine Glaspatte 6-1*, 6-2*, 6-3*, 6-4* als optisches Element zugeordnet. Die die Lichtauslenkeinheit 6* passierenden Lichtstrahlen bewirken auf dem Aufzeichnungsträger ( nicht dargestellt) die Aufzeichnung von Bildpunkten.

Die dem Streifenbereich ST1 zugeordnete Glasplatte ST1* (sie ist parallel zur Licht-Steuer-Einheit 4* angeordnet) bewirkt keine Auslenkung der vom Streifenbereich ST1* ausgehenden Lichtstrahlen. Sie dient dem Zweck, Laufzeitunterschiede zu den die anderen Glasplatten 6-2*, 6-3*, 6-4* passierenden Lichtstrahlen zu vermeiden.

Die dem Streifenbereich ST2* zugeordnete Glasplatte ST2* ist um den Winkel a ( dieser liegt in der Größenordnung von 0,3 grad) geneigt (bezogen auf eine parallel zur Licht-Steuer-Einheit 4* liegende Ebene E*) angeordnet.

Sie bewirkt einen Versatz der von dem Streifenbereich ST2* leitbaren Lichtstrahlen, was zur Aufzeichnung von in x-Richtung um den Betrag dx versetzten Bildpunkten führt.

Die dem Streifenbereich ST3* zugeordnete Glasplatte ST3* ist um den Winkel b ( dieser liegt in der Größenordnung von 2 x 0,3 grad) geneigt (bezogen auf eine parallel zur Licht-Steuer-Einheit 4* liegende Ebene E*) angeordnet.

Sie bewirkt einen Versatz der von dem Streifenbereich ST3* leitbaren Lichtstrahlen, was zur Aufzeichnung von in x-Richtung um den Betrag 2 x dx versetzten Bildpunkten führt.

Die dem Streifenbereich ST4* zugeordnete Glasplatte ST4* ist um den Winkel c ( dieser liegt in der Größenordnung von 3 x 0,3 grad; c>b) geneigt (bezogen auf eine parallel zur Licht-Steuer-Einheit 4* liegende Ebene E*) angeordnet.

Sie bewirkt einen Versatz der von dem Streifenbereich ST4* leitbaren Lichtstrahlen, was zur Aufzeichnung von in x-Richtung um den Betrag 3 x dx versetzten Bildpunkten führt.

Alle von den Licht-Steuer-Elementen eines Streifenbereiches leitbaren Lichtstrahlen zur Aufzeichnung von Lichtpunkten eines Teilbildes werden gleichzeitig um jeweils die gleiche x-Versatzstrecke versetzt.

Der Versatz der Lichtstrahlen für die einzelnen Streifenbereiche ST2*, ST3* und ST4* ist jeweils unterschiedlich.

Die Erfindung ist nicht - wie bisher erörtert- nur auf y-Verschiebeatrecken kleiner als die Seitenlänge eines Bildpunktes beschränkt.

Es folgen Erläuterungen für y- Verschiebestrecken bei der Bildaufzeichnung , welche größer als die Seiten-Länge eines Bildpunktes sind:

Länge einer Bildpunktseite L < y-Verschiebestrecke < 2L

Im Beispiel gemäß FIG.4 wurde davon ausgegangen, daß zwischen den Belichtungszeitpunkten t1 , t2, t3, t4, t5,...der Aufzeichnungsträger 1 jeweils um die kleinstmögliche y-Verschiebestrecke dy verschoben wird, welche im angegebenen Beispiel ¼ der Bildpunkt-Seitenlänge L beträgt. Die 4 in ¼ ist durch die Aufteilung der Licht-Steuer-Einheit in 4 Streifenbereiche bedingt. Zu jedem Belichtungszeitpunkt wird ein Teilbild aufgezeichnet.

Die Teilbilder sind so auf dem Aufzeichnungsträger positioniert,
daß ihre obere linke Ecke p1, p2, p3, ...jeweils mit der auf dem Aufzeichnungsträger angegebenben Position p1, p2, p3,... übereinstimmt.

Die Bildaufzeichnung kann erfindungsgemäß beschleunigt werden, wenn für die y-Verschiebestrecke zwischen aufeinanderfolgenden Belichtungszeitpunkten ein größerer Wert gemäß

Länge einer Bildpunktseite L < y-Verschiebestrecke < 2L gewählt wird. Für diesen Fall liegen die aufeinanderfolgenden Belichtungstzeitpunkte zeitlich weiter auseinander.

Diese y-Verschiebestrecke (mit der Dimension der Seitenlänge L eines Bildpunktes B) errechnet sich wie folgt:

**y-Verschiebestrecke = Seitenlänge L eines Bildpunktes + k : m**

k = 1, 2, 3, .....(m-1) ; k ist ganzzahlig und läuft bis maximal (m-1)

m= 2, 3, 4, 5,... ; m ist ganzzahlig und entspricht der Anzahl der Streifenbereiche, Ausgenommen sind y-Verschiebestrecken in ungekürzter Zähler / Nenner Schreibweise, bei denen Zähler und Nenner einen gemeinsamen Teiler haben.

(Die Anzahl der Reihen von Licht-Steuer-Elementen in der Licht-Steuer-Einheit muß immer durch m teilbar sein, da jeder Streifenbereich die gleiche Reihen-Anzahl umfaßt).

Dieser Zusammenhang wird anhand der nachfolgenden Beipiele erläutert.

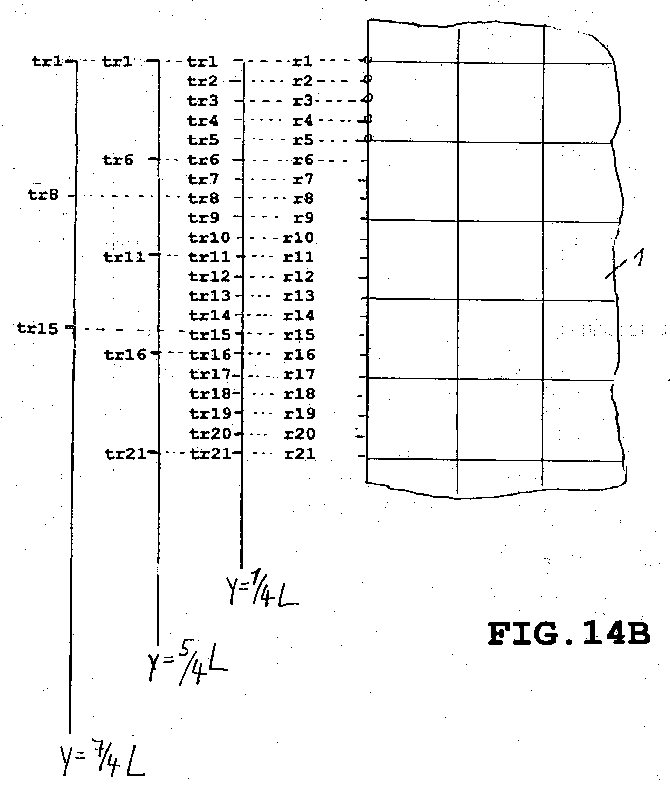

Beispiel 1 gemäß Darstellung in FIG.14A und FIG. 14B):

Eine Licht-Steuer-Einheit aus 12 x 12 Licht-Steuer-Elementen wird in 4 (m=4) Stufenbereiche ST1', ST2', ST3' und ST4' aufgeteilt. Jeder Stufenbereich umfaßt 3 Reihen von Licht-Steuer-Elementen (FIG.14 A).

Die Aufteilung in 4 Stufenbereich bedingt -in Analogie zum Beispiel gemäß FIG.4- eine kleinstmögliche y-Verschiebestrecke von 1/4 der Seitenlänge L eines Bildpunktes B (und eine kleinstmögliche x-Versatzstrecke von ebenfalls 1/4 der Seitenlänge eines Bildpunktes).

Erfindungsgemäß kann die Teilbildaufzeichnung aber auch zu Belichtungszeitpunkten erfolgen, die zeitlich weiter auseinanderliegen, wobei sich der Aufzeichnungsträger zwischen solchen aufeinanderfolgenden Belichtungszeitpunkten um eine größere äquidistante Verschiebestrecke verschoben hat.

FIG. 14B zeigt
die schematische Darstellung eines Aufzeichnungsträgers (in Analogie zu FIG.4) mit einem Positions-Netzgitter für die Aufzeichnung von Teilbildern unter Berücksichtigung von FIG. 14A für unterschiedliche jeweils äquidistante y-Verschiebestrecken (y= ¼ L; 5/4 L und 7/4 L, wobei L die Seitenlänge L eines Bildpunktes R ist.)

Die Aufzeichnung von Teilbildern könnte zu den Belichtungszeitpunkten tr1, tr2, tr3, tr4, tr5, tr6, tr7,... erfolgen, wobei zwischen zwei aufeinanderfolgenden Belichtungszeitpunkten der Aufzeichnungsträger um den kleinstmöglichen y- Verschiebewert Wert = 1/4 der Seitenlänge L eines Bildpunktes vorschoben wird. Bei der Aufzeichnung der Teilbilder (nicht dargestellt) auf dem Aufzeichnungsträger sind diese auf die Positionen r1, r2, r3, r4, ... ausgerichtet. Für äquidistante y-Verschiebestrecken von jeweils ¼ L liegen die Belichtungszeitpunkte tr1, tr2, tr3, tr4,.... auf dem "Zeitstrahl" für ¼ L.

Erfindungsgemäß kann die Teilbildaufzeichnung aber auch zu Belichtungszeitpunkten erfolgen, die zeitlich weiter auseinanderliegen, wobei sich der Aufzeichnungsträger zwischen solchen aufeinanderfolgenden Belichtungszeitpunkten um eine größere äquidistante Verschiebestrecke verschoben hat.

Für äquidistante y-Verschiebestrecken von jeweils 5/4 L liegen die Helichtungszeitpunkte bei tr1, tr6, tr1, tr 16,...gemäß der Darstellung auf dem "Zeitstrahl" für 5/4 L in FIG. 14B.

Für äquidistante y-Verschiebestrecken von jeweils 7/4 L liegen die Belichtungszeitpunkte bei tr1, tr8, tr15, tr 22,...gemäß der Darstellung auf dem "Zeitstrahl" für 7/4 L in FIG. 14B.

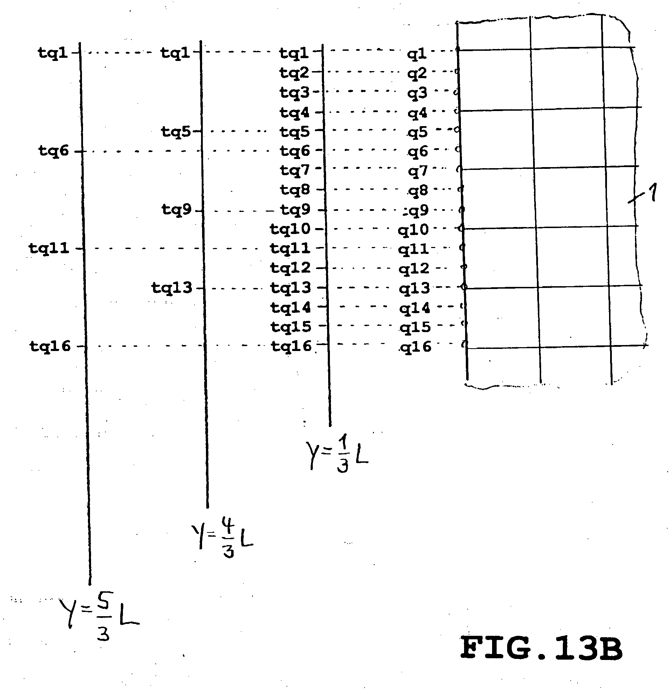

Beispiel 2 gemäß Darstellung in FIG.13A und FIG. 13B):

Eine Licht-Steuer-Einheit aus 9x9 Licht-Steuer-Elementen wird in 3 (m=3) Stufenbereiche ST1", ST2", ST3" aufgeteilt. Jeder Stufenbereich umfaßt 3 Reihen von Licht-Steuer-Elementen (FIG.13 A).

Die Aufteilung in 3 Stufenbereiche bedingt - in Analogie zum Beispiel gemäß FIG.4 - eine kleinstmögliche y-Verschiebestrecke von 1/3 der Seitenlänge L eines Bildpunktes B (und eine kleinstmögliche x-Versatzstrecke von ebenfalls 1/3 der Seitenlänge eines Bildpunktes).

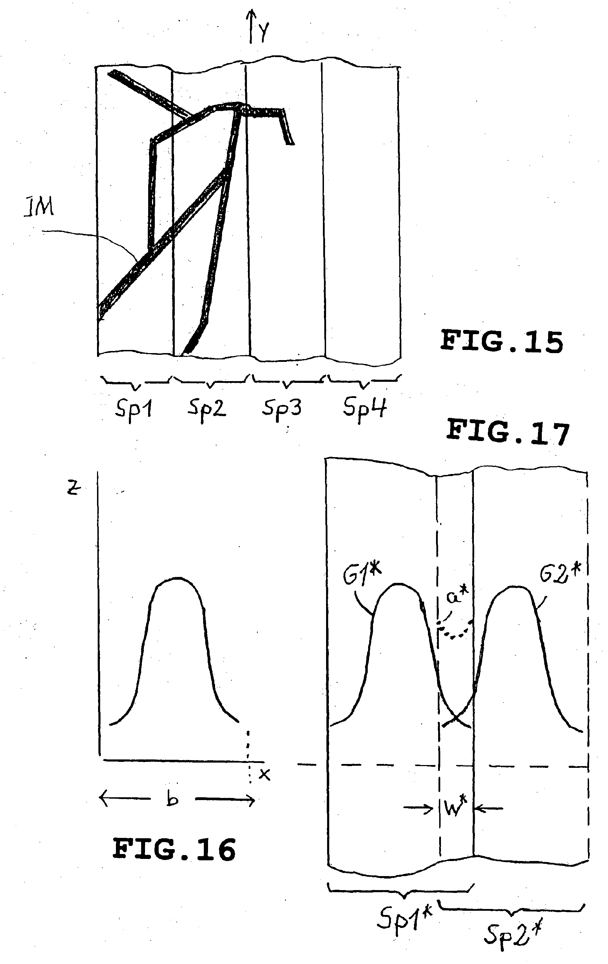

FIG. 15B zeigt
die schematische Darstellung eines Aufzeichnungsträgers (in Analogie zu FIG.4) mit einem Positions-Netzgitter für die Aufzeichnung von Teilbildern gemäß FIG. 13A für unterschiedliche jeweils äquidistante y- Verschiebestrecken ( y= 1/3 L; 4/3 L und 5/3 L, wobei L die Seitenlänge eines Bildpunktes ist.)

Die Aufzeichnung von Teilbildern könnte (in Analogie zu FIG. 4) zu den Belichtungszeitpunkten tq1, tq2, tq3, tq4, tq5, tq6, tq7,... erfolgen, wobei zwischen zwei aufeinanderfolgenden Belichtungszeitpunkten der Aufzeichnungsträger um den kleinstmöglichen y- Verschiebewert Wert = 1/3 der Seitenlänge L eines Bildpunktes verschoben wird. Bei der Aufzeichnung der Teilbilder (nicht dargestellt) auf dem Aufzeichnungsträger sind diese (in Analogie zu FIG. 4) auf die Positionen q1, q2, q3, q4, ... ausgerichtet.

Für äquidistante y-Verschiebestrecken von jeweils 1/3 L liegen die Belichtungszeitpunkte tq1, tq2, tq3, tq4,.... auf dem "Zeitstrahl" für 1/3 L.

Nachfolgend wird die Berechnung der Zahlenwerte gemäß

**y-Verschiebestrecke = Seitenlänge L eines Bildpunktes + k : m**

k = 1, 2, 3, ....(m-1) ; k ist ganzzahlig und läuft bis maximal (m-1)

m= 2, 3, 4, 5,... ; m ist ganzzahlig und entspricht der Anzahl der Streifenbereiche, <u>Ausgenommen</u> sind y-Verschiebestrecken in ungekürzter Zähler / Nenner Schreibweise, bei denen Zähler und Nenner einen gemeinsamen Teiler haben.

für Beispiel 2 und Beispiel 1 nochmals zusammengefaßt:

Beispiel 2 :

m=3 ; m ist ganzzahlig und entspricht der Anzahl der Streifenbereiche,
k = 1, 2 ; k ist ganzzahlig und läuft von 1 bis maximal (m-1)= (3-1)= 2
für k=1 ist

```
y-Verschiebestrecke = 1 x Seitenlänge L eines Bildpunktes + 1/3
                          der Seitenlänge L eines Bildpunktes
                    = 3/3 Seitenlänge L eines Bildpunktes + 1/3
                          der Seitenlänge L eines Bildpunktes
                    = 4/3 der Seitenlänge eines L Bildpunktes
```

für k=2 ist

```
y-Verschiebestrecke = 2 x Seitenlänge L eines Bildpunktes + 2/3
                          der Seitenlänge L eines Bildpunktes
                    = 3/3 Seitenlänge L eines Bildpunktes + 2/3
                          der Seitenlänge L eines Bildpunktes
                    = 5/3 der Seitenlänge L eines Bildpunktes
```

Beispiel 1:

m=4 m ist ganzzahlig und entspricht der Anzahl der Streifenbereiche,
k = 1; 2; 3. k ist ganzzahlig und läuft von 1 bis maximal (m-1)= (4-1)= 3
für k=1 ist

```
y-Verschiebestrecke = 1 x Seitenlänge L eines Bildpunktes + 1/4
                          der Seitenlänge L eines Bildpunktes
                    = 4/4 Seitenlänge L eines Bildpunktes + 1/4
                          der Seitenlänge L eines Bildpunktes
                    = 5/4 der Seitenlänge L eines Bildpunktes
```

für k=2 ist

$$\text{y-Verschiebestrecke} = 1 \text{ x Seitenlänge L eines Bildpunktes} + 2/4 \text{ der Seitenlänge L eines Bildpunktes}$$

$$= 4/4 \text{ Seitenlänge L eines Bildpunktes} + 2/4 \text{ der Seitenlänge L eines Bildpunktes}$$

$$= 6/4 \text{ der Seitenlänge L eines Bildpunktes}$$

entfällt, da 6/4 noch (auf 3/2) gekürzt werden kann oder weil in 6/4 Zähler und Nenner noch einen gemeinsamen Teiler haben
für k=3 ist

$$\text{y-Verschiebestrecke} = 1 \text{ x Seitenlänge L eines Bildpunktes} + 3/4 \text{ der Seitenlänge L eines Bildpunktes}$$

$$= 4/4 \text{ Seitenlänge L eines Bildpunktes} + 3/4 \text{ der Seitenlänge L eines Bildpunktes}$$

$$= 7/4 \text{ der Seitenlänge L eines Bildpunktes}$$

In den vorgenannten Beispielen 1 und 2 ist Länge einer Bildpunktseite L < y-Verschiebestrecke < 2L

Erfingdungsgemäß kann jedoch die y-Verschiebestrecke auch größer als die 2fache Seitenlänge(2L) eines Bildpunktes sein:

2fache Seitenlänge (2L) eines Bildpunktes < y-Verschiebestrecke

Sie wird wie folgt berechnet:

$$\text{y-Verschiebestrecke} = u \text{ x Seitenlänge eines Bildpunktes} + k/m$$

u= 1;2; 3; ..... (m-1) ganzzahlig
m= Anzahl der Streifenbereiche= 2; 3; 4;...

Ausgenommen sind y-Verschiebestrecken, bei denen in ungekürzter Zähler / Nenner Schreibweise Zähler und Nenner einen gemeinsamen Teiler haben.

Bei allen zulässigen y-Verschiebestrecken

a) y-Verschiebestrecke < Seitenlänge L eines Bildpunktes;
b) Länge einer Bildpunktseite L < y-Verschiebestrecke < 2L
c) y-Verschiebestrecke > als die zweifache Seitenlänge L eines Bildpunktes

wird das Gesamtbild aus der Überlagerung sich überlappender Teilbilder gebildet.

Für das Gesamtbild bleibt die Auflösung auch für die Fälle b und c erhalten, wenn eine größere y-Verschiebestrecke gewählt wird.

Bei kleineren y-Verschiebestrecken (a) kann eine eventuelle Mehrfachbelichtung von Bildteilen gegeben sein. Bei größeren y- Verschiebe-Strecken (b), c)) kann eine nicht ausreichende Belichtung (durch Fehlen von Mehrfachbelichtung) durch Verwerdung stärkerer Lichtquellen ausgeglichen werden. Allen zulässigen y-Verschiebestrecken (a), b) und c)) ist gemeinsam, daß sie Bruchteile der Seitenlänge eines Bildpunktes mit umfassen.

Der seitliche x-Versatz der Lichtstrahlen erfolgt auch bei größeren y-Verschiebestrecken (gemäß b) und c)) nach dem gleichen Prinzip wie im Zusammenhang mit FIG. 4 beschrieben.

Das erfindungsgemäße Verfahren ist in allgemeiner Formulierung durch folgende erfindungsspezifische Verfahrensschritte gekennzeichnet:

a) der Aufzeichnungsträger (1) wird für jeden Balichtungszeitpunkt (t1, t2, t3, t4, ...) gegenüber der Licht-Steuer-Einheit (oder umgekehrt) in y-Richtung aufeinanderfolgend um jeweils eine äquidistante y-Verschiebestrecke verschoben. Der Betrag von der y-Verschiebestrecke umfaßt immer einen Bruchteil der Länge der Seite L eines Bildpunktes (P).

b) in einem Teilbild (T1, T2, T3,..) werden bestimmte Bildpunkte unter Berücksichtigung der nachfolgenden Verfahrensschritte c), d) und e) in x -Richtung um eine x-Versatzstrecke optisch versetzt aufgezeichnet - bezogen auf gedachte unversetzt aufgezeichnete Bildpunkte-,
wobei die x-Versatzstrecke kleiner ist als die Länge der Seite (p) eines Bildpunktes (P). Die x-Versatzstrecke hat den Betrag
dx oder (i) dx = i multipliziert mit dx ;
wobei dx = (1/m)p= (1/m) multipliziert mit p
ist für ein ganzzahliges m= 2, 3, 4,...
oder wobei
(i)dx = (i) multipliziert mit dx
ein ganzzahliges Vielfaches von dx ist für
i= 1, 2, 3, ...(m-1).

c) die Licht-Steuer-Elemente der Licht-Steuer-Einheit(4) werden untereinanderliegenden horizontalen gedachten Streifenbereichen (ST1, ST2, ST3, ....) zugeordnet. Jeder Streifenbereich (ST1, ST2, ST3, .....) umfaßt die gleiche Anzahl von Licht-Steuer-Elementen und die gleiche Anzahl von Reihen von Licht-Steuer-Elementen.

Die Anzahl der Streifenbereiche kann 2 oder 3 oder 4 oder 5 sein.
(Anmerkung: eine 2x2 Licht-Steuer-Einheit kann nur in 2 Streifenbereiche aufgeteilt werden;
eine 4x4 Licht-Steuer-Einheit entvieder in 2 (in diesem Fall ist m=2) oder 4 (in diesem Fall ist m=2) Streifenbereiche;
eine 6x6 Licht-Steuer-Einheit in 2 (in diesem Fall ist m=2) oder 3 (in diesem Fall ist m=3) Streifenbereiche;
eine 8x8 Licht-Steuer-Einheit in 2 oder 4 Streifenbereiche; eine 10x10 Licht-Steuer-Einheit in 2 oder 5 Streifenbereiche ;
eine 12x12 Licht-Steuer-Einheit in 2 oder 4 Streifenbereiche. etc etc).

d) im obersten ersten Streifenbereich ST1 der Lichtsteuer-Einheit werden die Licht-Steuer-Elemente aktiviert für in x-Richtung unversetzt aufzuzeichnenden Bildpunkte.

In dem unter dem ersten Streifeinbereich ST1 liegenden zweiten Streifönbereich ST2 werden die Licht-Steuer-Elemente aktiviert für die in x-Richtung um die x-Versatzstrecke = 1 mal dx versetzt aufzuzeichnenden Bildpunkte.
In dem gegebenenfalls unter dem zweiten Streifenbereich (ST2) liegenden dritten Streifenbereich ST3- falls ein solcher vorgesehen ist- werden die Licht-Steuer-Elemente aktiviert für die in x-Richtung um die x-Versatzstrecke 2 mal dx versetzt aufzuzeichnenden Bildpunkte.
In dem gegebenenfalls unter dem dritten Streifenbereich ST3 liegenden vierten Streifenbereich ST4 (falls ein solcher vorgesehen ist- werden die Licht-Steuer-Elemente aktiviert für die in x-Richtung um die x-Versatzstrecke 3 mal dx versetzt aufzuzeichnenden Bildpunkte, ..... etc.
Die x-Versatzstrecke für aufzuzeichnende Bildpunkte nimmt von Streifenbereich zu Streifenbereich (ST1/ST2; ST2/ST3; ST3/ST4),.....) um jeweils 1 mal dx zu.

e) die von den Licht-Steuer-Elementen eines Streifenbereiches der Lichtsteuer-Matrix ausgehenden Lichtstrahlen zur Aufzeichnung von in x Richtung versetzten Bildpunkten werden gemeinsam versetzt.

Die y- Verschiebestrecke
(dy) kann eine Größe haben, die Bruchteilen der Länge L eines Bildpunktes entspricht, wobei

$$\mathbf{dy= (1/s)L = (1/s) \ multipliziert \ mit \ L}$$

für ein ganzzahliges s= 2, 3, 4, ...;
Die y-Verschiebestrecke aber auch eine Größe gemäß der Beziehung haben

$$\mathbf{y\text{-}Verschiebestrecke = u \ x \ Seitenlänge \ L \ eines \ Bildpunktes + k/m}$$

u= 1; 2; 3;...

k= 1;2; 3; ..... (m-1) ganzzahlig

m= Anzahl der Streifenbereiche= 2; 3; 4;...

wobei y-Verschiebestrecken ausgenommen sind, bei denen in ungekürzter Zähler / Nenner Schreibweise Zähler und Nenner einen gemeinsamen Teiler haben.

Grundsätzlich können die y-Verschiebestrecke dy und die x Versatzstrecke dx unterschiedlich groß sein. Jedoch ist nur bei Gleichheit beider Werte das Bild-Auflösung in x- und in y-Richtung gleich.

Die erfindungsgemäße Anordnung ist in allgemeiner Formulierung durch folgende erfindungsspezifische Merkmale gekennzeichnet:

die y-Verschiebe-Strecke hat einen Wert, welcher einen Bruchteil der Länge (L) einer Seite eines Bildpunktes (R) einschließt,

zwischen der Licht-Steuer-Einheit (4*) und dem Aufzeichnungsträger (1*) ist eine Anordnung (6*) zum Versatz lichtpunkterzeugender Lichtstrahlen in x-Richtung angeordnet,

wobei die x-Versatzstrecke einen Bruchteil der Länge (L) der Seite eines Bildpunktes beträgt und der Maximalwert einer x-Versatzstrecke kleiner ist als die Länge (L) der Seite eines Bildpunktes.

Als Licht-Einheit wird vorzugsweise eine LED -Einheit (Einheit mit Licht Emittierende Dioden) für gepulstes Licht verwendet.

FIG. 15 zeigt

eine schematische Darstellung eines Aufzeichnungsträgers mit spaltenweiser Bildaufzeichnung.

Das aufzuzeichnende Bild IM erstreckt sich über mehrere nebeneinanderliegende Bildflächenspalten Sp1, Sp2, Sp3, Sp4. Die Bildaufzeichnung erfolgt spaltenoreise: Die Belichtungsfläche in der Belichtungsstation hat die Breite b eines Streifens. Der Aufzeichnungsträger wird gegenüber der Licht-Steuer-Einheit ( nicht dargestellt) in Richtung y bewegt. Bei der BildAufzeichnung in einer Spalte werden erfindungsgemäß die Teilbilder teilweise überlagert.

Nach der Bildaufzeichnung in einer Spalte wird die Verschiebeinrichtung, auf der der Aufzeichnungsträger angeordnet ist, zurückgesetzt und seitwärts um Spaltenbreite verschoben. Dann beginnt die Bildaufzeichnung in der nächsten Spalte usw. FIG.15 zeigt den aktuellen Stand einer Bildaufzeichnung IM, welche schon für die Streifen Sp1, Sp2 und einen Teil des Streifens Sp3 erfolgt ist.

Die Aufzeichnung einander teilweise überlagernder Teilbilder bedingt eine Verbesserung der Homogenität der Bildqualität (der Aufzeichnungsstärke) der einzelnen Bildpunkte an den Bildpunkt-Rasterpositionen in Richtung der Bewegungsrichtung y des Aufzeichnungsträgers.

Senkrecht zu dieser Bewegungsrichtung können sich allerdings Abweichungen von einer homogenen Aufzeichnungsstärke ergeben.

FIG.16 zeigt

eine Darstellung der Funktion der Aufzeichnungsstärke z für Bildpunkte in Abhängigkeit von ihrer Position quer zur Beovegungsrichtung y des Aufzeichnungsträgers, also entlang der Breite b eines Teilbildes. Diese Funktion kann einen Gaußkurvenähnlichen Verlauf aufweisen; die Aufzeichnungsstärke ist in der Mitte des Teilbildes höher als an seinen seitlichen Rändern.

Zur Verringerung solcher Abweichungen werden zunächst diese Abweichungen (senkrecht zur Bewegungsrichtung y) meßtechnisch als Funktion des Ortes erfaßt.

Unter Berücksichtigung und zur Verringerung dieser Abweichungen können die Licht-Steuer-Elemente in der Licht-Steuer-Einheit computerprogrammgesteuert derart gesteuert werden, daß in den Teilbildern Licht-Steuer-Elemente (für Bildpunkte ursprünglich zu hoher Aufzeichnungsstärke) deaktiviert werden

Alternativ kann aber auch zwischen der Licht-Steuer-Einheit und dem Aufzeichnungsträger ein diese Abweichungen verringerndes optisches Filter (nicht dargestellt) angeordnet werden.

Eine weitere Möglichkeit zur Verringerung solcher Abweichungen liegt in einer spaltenareisen Bildaufzeichnung mit sich randwärts überlagernden Bildspalten.

FIG.17 zeigt

eine schematische Darstellung zweier sich randwärts überlagernder Spalten Sp1* und Sp2* für die Bildaufzeichnung, wobei jede Spalte einen Gaußkurven-ähnlichen Verlauf G1*, G2* der Aufzeichnungsstärke der Bildpunkte gemäß FIG.16 aufweist. Für die Bildaufzeichnung im Überlagerungs-Bereich w* ergibt sich eine Überlagerung der Aufzeichnung in Spalte Sp1* mit der in Süpalte Sp2*.

Die Aufzeichnung in Spalte Sp1* erfolgt unter Berücksichtigung der Kurve G1*; die in Spalte Sp2* unter Berücksichtigung der Kurve G2*, so daß sich insgesamt gesehen für die Aufzeichnung eines Bildpunktes im Überlagerungs-Bereich w* eine Aufzeichnungsstärke ergibt, welche aus der Addition der Ordinatenwerte der Kurven G1* und G2* folgt (gepunktete Darstellung a*).

Die Verschiebung des Aufzeichnungsträgern gegenüber der Licht-Steuer-Einheit bzw. der Licht-Steuer-Einheit gegenüber dem Aufzeichnungsträger kann auch im Start-Stop-Betrieb erfolgen. Die Umsetzung des Steuermusters der Licht-Steuer-Einheit in steuerbare Lichtstrahlen zur Bildaufzeichnung kann auf unterschiedliche Art und Weise erfolgen, z.B.

a) über ein gepulstem Licht beausfschlagtes Kippspiegel-Elemente-Halbleiter-Chip,
b) über eine Matrix mit gepulstem Licht beausfschlagter steuerbarer Licht-Ventil-Elemente.
c) über eine Matrix gepulstes Licht emittierender Elemente.

Die Belichtung des Aufzeichnungsträgers mit gepulstem Licht gleicher oder nahezu gleicher Lichtenergie bedingt erfindungsgemäß Aufzeichnungen mit durchgehender Aufzeichnungstiefe, d.h.,
die belichteten Stellen erfassen die ganze Schichtdicke der lichtempfindlichen Schicht und werden in dem auf die Belichtung folgenden Ätzprozeß weggeätzt.

Erfingdungsgemäß ist es jedoch auch möglich, Aufzeichnungen mit unterschiedlicher Aufzeichnungstiefe zu erzeugen:

Hierfür erfolgt die Aufzeichnung eines Bildes in mehreren Durchläufen des Aufzeichnungsträgers durch die Belichtungsstation. In jedem Durchlauf erfolgt die Belichtung des Aufzeichnungsträgers mit gepulstem Licht gleicher oder nahezu gleicher Lichtenergie, jedoch ist die Lichtenergie pro Durchlauf unterschiedlich. Die Verschiebe-Einrichtung muß pro Durchlauf von derselben Ausgangsposition in Verschieberichtung y gestartet werden.

Hierdurch können erfindungsgemäß dreidimensionalen Strukturen in der lichtempfindlichen Schicht erzeugt werden. Solche Strukturen können als optische Elemente zur optischen oder Phasen-Fokussierung verwendet werden, z.B. als Linse oder Linsen-Feld zur optischen Fokussierung von Licht,
oder zur Phasen-Fokussierung von Licht, z.B. in sogenannten Fresnel-Beugungsgittern.

Es ist bekannt, eine Lichtbündelung durch Einsatz eines auf dem Huygenschen Prinzip beruhenden Fresnel-Beuqungsgitter zu bewirken (derartige Beugungsgitter sind als sogenannte Fresnel-zone-plates in der Druckschrift "OPTICS", Hecht & Zajac, 1974 by Addison-Wesley Publishing Company, beschrieben. Ein solches lichtovellenlängenspezifisches Beugungsgitter wird durch ebene konzentrische auf lichtdurchlässigem Trägermaterial aufgebrachte Ringe aus Crom oder Photoemulsionen gebildet.

Das Beugungsgitter bewirkt, daß auftreffendes Licht durch die in der Mitte dieses Gitters angeordnete ( z.B. runde) Öffnung geleitet wird.

Der auf die Ringe auftreffende Lichtanteil geht üblicherweise durch Reflektion verloren, es sei, die Ringe bestehen aus einem Material, welches eine Phasenverschiebung das auftreffenden Lichtes um die halbe Lichtwellenlänge bewirkt (o.g. Fundstelle, Seite 376, "phase reversal zone plate").In diesem Fall wird auch der auf die Ringe auftreffende Teil des Lichtes durch die Öffnung geleitet. Der Einsatz Fresnelscher Beugungsgitter ist nach dem Stand der Technik für bestimmte Anwendungszwecke bekannt (z.B. Telekommunikation, Laser-Fokussierung). Diese Beugungsgitter können auch eine von der Kreisform abweichende z.B. elliptische Gestaltung erfahren, um Korrekturen von optischen Verzerrungen der verwendeten Linsensysteme zu bewirken (Ausgleich der Lichteinfallswinkel bei nicht kollimierten Licht).

Die Erfindung ist durch Verwendung monochromatischen Lichtes im ultravioletten Bereich oder durch Verwendung nicht monochromatischen Lichtes mit einem Hauptanteil im ultravioletten Bereich realisierbar. Im Handel sind z.B. UV Licht verträgliche Kippspiegel-Elemente-Halbleiter-Chips (z.B. "UV DLP" (digital light processing) der Firma Texas Instruments/ U.S.A.) und
UV Licht sensitive Aufzeichnungsträger (z.B. "LDI 330 Resist" der Firma Dupont / U.S.A.) verfügbar.

Nach der Erfindung können fotographische Vorlagen für gedruckte Leiterplatten hergestellt werden. Vorzugsweise ermöglicht die Erfindung auch eine Direktbelichtung von mit einer fotoempfindlichen Schicht versehenen Leiterplattenmaterial, welches aus einer elekrisch leitfähigen Metallschicht und einer nichtleitenden Trägerschicht besteht.

Bei einer solchen Direktbelichtung entfällt die sonst erforderliche fotografische Vorlage, da die Leiterplatte direkt (ohne Zwischenschaltung einer fotographischen Vorlage) belichtet wird.

Die Erfindung kann auch der Erstellung von Druckformen für den Hoch-, Tief-, Flach-, Durch- und Siebdruck dienen.

In den Fällen, in denen ein aufzuzeichnendes Bild die Breite b der Belichtungsstation übersteigt, kann erfindungsgemäß die Aufzeichnung des Bildes in mehreren Durchläufen des Aufzeichnungsträgers durch die Belichtungsstation erfolgen.

In jedem Durchlauf wird eine "Bild- Spalte" des gedachten Gesamtbildes erzeugt wird. Für einen solchen Fall muß die Verschiebeeinrichtung nicht nur in Richtung y verschieblich sein, sondern auch noch senkrecht dazu.

Die Erfindung kann somit in den verschiedensten Anwendungsgebieten benutzt werden, welche die Aufzeichnung eines Rasterbildes auf einen lichtempfindlichen Aufzeichnungsträger voraussetzen.

Es sind auch Anwendungen denkbar, in denen der lichtempfindliche Aufzeichnungsträger nicht aus einem chemisch zu entwickelndem Material besteht, sondern aus einem Material, welches bei Belichtung elektrische Aufladungen erfährt, die wiederum ladungssensitiven abdruckfähigen Toner anziehen bzw. abstoßen.

Die Verschiebe-Einrichtung kann eine Schrittmotor-gesteuerte Einrichtung, eine Linearmotor-gesteuerte Einrichtung, eine piezokristall-gesteuerte Einrichtung sein, ebenso auch eine Kombination aus den vorgenannten Einrichtungen.

**Patentansprüche**

1. Verfahren zur Aufzeichnung eines computergespeicherten Rasterbildes auf einen ebenen lichtempfindlichen Aufzeichnungsträger als ein aus Bildpunkten bestehendes Rasterbild in x/y Koordinatenrichtung,

   bei dem das Rasterbild mittels Belichtung einer mit Steuermustern per Computerprogramm beaufschlagten Licht-Steuer-Einheit (4\*) erzeugt wird,

   wobei die Licht-Steuer-Einheit (4\*) aus matrixartig angeordneten Licht-Steuer-Elementen (c\*) besteht, wobei von jedem Licht-Steuer-Element ein steuerbarer Lichtstrahl zur Aufzeichnung eines Bildpunktes auf den Aufzeichnungsträger leitbar ist an eine ihm zugeordnete Position einer Aufzeichnungsfläche in einer Belichtungsstation,

   wobei der Aufzeichnungsträger gegenüber der Licht-Steuer-Einheit (oder umgekehrt) verschoben wird,

   und wobei der Abstand der Ebenen, in welchen der Aufzeichnungsträger und die Licht-Steuer-Einheit (4\*) liegen, gleichbleibend ist,

   wobei der Aufzeichnungsträger gegenüber der Licht-Steuer-Einheit (oder umgekehrt) eine kontinuierliche oder schrittweise geradlinige Bewegung in y-Richtung ausführt

   wobei für Belichtungszeitpunkte (t1, t2, t3,...) jeweils ein Steuermuster in die Licht-Steuer-Einheit geladen wird für die Aufzeichnung eines vom Steuermuster abgeleiteten Teilbildes (T1, T2, T3,...) in der Belichtungsstation,

   wobei die Belichtungsstation immer die gleiche Position bezüglich der Licht-Steuer-Einheit (4\*) einnimmt, wobei die Aufzeichnung aller Bildpunkte eines Teilbildes. (T1, T2, T3,...) gleichzeitig erfolgt,

   wobei der Aufzeichnungsträger zwischen zwei aufeinanderfolgenden Belichtungszeitpunkten in y-Richtung um eine äquidistante y-Verschiebestrecke verschoben wird,

   **dadurch gekennzeichnet,**

   a)
   **daß** in einem Teilbild (T1, T2, T3,) bestimmte Bildpunkte unter Berücksichtigung der Verfahrensschritte b), c) und d)

   in x -Richtung um eine x-Versatzstrecke optisch versetzt aufgezeichnet werden- bezogen auf gedachte unversetzt aufgezeichnete Bildpunkte-,

   wobei die x-Versatzstrecke den Betrag

$$dx = (1/m)L = (1/m) \text{ multipliziert mit } L$$

   für ein ganzzahliges m= 2, 3, 4,... als Bruchteil der Länge (L) einer Seite eines Bildpunktes (R) oder den Betrag
   (i)dx = (i) multipliziert mit dx
   als ein ganzzahliges Vielfaches von dx für i= 1, 2, 3, ...(m-1);
   hat
   b)
   **daß** die Licht-Steuer-Elemente der Licht-Steuer-Einheit(4) untereinanderliegenden horizontalen gedachten Streifenbereichen (ST1, ST2, ST3, .....; STk für k= 1 bis m und für und m= 2, 3, 4,...) zugeordnet werden, wobei jeder Streifenbereich (ST1, ST2, ST3, .....) die gleiche Anzahl von Licht-Steuer-Elementen und die gleiche Anzahl von Reihen von Licht-Steuer-Elementen aufweist,
   c)
   **daß** im obersten ersten Streifenbereich (ST1) der Lichtsteuer-Einheit die Licht-Steuer-Elemente für die in x-Richtung unversetzt aufzuzeichnenden Bildpunkte aktiviert overden,
   **daß** in dem unter dem ersten Streifenbereich (ST1) liegenden zweiten Streifenbereich ST2 die Licht-Steuer-Elemente für die in x-Richtung um die x-Versatzstrecke = 1 mal dx versetzt aufzuzeichnenden Bildpunkte aktiviert werden
   **daß** in dem gegebenenfalls unter dem zweiten Streifenbereich (ST2) liegenden dritten Streifenbereich (ST3) die Licht-Steuer-Elemente für die in x-Richtung um die x-Versatzstrecke 2 mal dx versetzt aufzuzeichnenden Bildpunkte aktiviert werden,

**daß** in dem gegebenenfalls unter dem dritten Streifenbereich (ST3) liegenden vierten Streifenbereich (ST4) die Licht-Steuer-Elemente für die in x-Richtung um die x-Versatzstrecke 3 mal dx versetzt aufzuzeichnenden Bildpunkte aktiviert werden,

und **daß** in gegebenfalls weiteren Streifenbereichen die Licht-Steuer-Elemente analog zu den vorstehenden Schritten aktiviert werden,

wobei die x-Versatzstrecke für aufzuzeichnende Bildpunkte von Streifenbereich zu Streifenbereich (ST1/ST2; ST2/ST3; ST3/ST4),.....) um jeweils 1 mal dx zunimmt.

d)

**daß** die von den Licht-Steuer-Elementen eines Streifenbereiches der Lichtsteuer-Matrix ausgehenden Lichtstrahlen zur Aufzeichnung von in x Richtung versetzten Bildpunkten gemeinsam versetzt werden;

e) **daß** der optische Versatz der Lichtstrahlen in x-Richtung für alle für einen solchen Versatz vorgesehenen Streifenbereiche gleichzeitig erfolgt.

2.  Verfahren nach Anspruch 1,
    **dadurch gekennzeichnet, daß** die y- Verschiebestrecke (dy) eine Größe hat, die Bruchteilen der Länge L eines Bildpunktes entspricht, wobei

$$dy= (1/s)L = (1/s) \text{ multipliziert mit } L$$

ist für ein ganzzahliges s= 2, 3, 4, ...;

3.  Verfahren nach Anspruch 1,
    **dadurch gekennzeichnet, daß** die y-Verschiebestrecke eine Größe hat gemäß der Beziehung

$$y\text{-Verschiebestrecke} = u \text{ x Seitenlänge } L \text{ eines Bildpunktes} + k/m$$

u= 1; 2; 3;...
k= 1;2; 3; ..... (m-1) ganzzahlig
m= Anzahl der Streifenbereiche= 2; 3; 4;...

wobei y-Verschiebestrecken ausgenommen sind, bei denen in ungekürzter Zähler / Nenner Schreibweise Zähler und Nenner einen gemeinsamen Teiler haben.

4.  Verfahren nach Anspruch 1 und 2,
    **dadurch gekennzeichnet,**
    **daß** die y-Verschiebestrecke gleich der kleinsten x-Versatzstrecke ist.

5.  Verfahren nach Anspruch 1,
    **dadurch gekennzeichnet,**
    **daß** die Licht-Steuer-Einheit (4) mit von einer LED - Einheit (Einheit mit Licht Emittierende Dioden) ausgehendem gepulsten Licht beaufschlagt wird.

6.  Verfahren nach Anspruch 1,
    **dadurch gekennzeichnet,**
    **daß** die Umsetzung des Computer-Rasterbildes in steuerbare Lichtstrahlen zur Bildaufzeichnung über ein mit gepulstem Licht beaufschlagtes Kippspiegel-Elemente-Halbleiter-Chip erfolgt.

7.  Verfahren nach Anspruch 1,
    **dadurch gekennzeichnet**,
    die Umsetzung des Computer-Rasterbildes in steuerbare Lichtstrahlen zur Bildaufzeichnung über eine Matrix steuerbarer Licht-Ventil-Elemente erfolgt
    oder

die Umsetzung des Computer-Rasterbildes in steuerbare Lichtstrahlen zur Bildaufzeichnung über eine Matrix Blitzlicht emittierender Elemente erfolgt.

8. Verfahren nach Anspruchche 1,
**dadurch gekennzeichnet, daß**
die Größe des in der Belichtungsstation (6) erzeugten Teilbildes durch ein zwischen der Licht-Steuer-Einheit (4) und dem Aufzeichnungsträger (1) angeordnetes maßstabsbestimmendes Objektiv (7) bestimmt wird.

9. Verfahren nach einem der Ansprüche 1 bis 8,
**dadurch gekennzeichnet, daß**
der Aufzeichnungsträgers (1) gegenüber der Licht-Steuer-Einheit (4) mit kontinuierlicher Bewegung oder schrittweise verschoben wird.

10. Verfahren nach einem der Ansprüche 1 bis 9,
**dadurch gekennzeichnet,**
**daß** die Bildaufzeichnung mit gepulstem Licht gleicher oder nahezu gleicher Blitzenergie erfolgt zur Erzeugung einer durchgehenden Aufzeichnungstiefe im Aufzeichnungsträger (1).

11. Verfahren nach einem der Ansprüche 1 bis 10,
**dadurch gekennzeichnet,**
**daß** die Bildaufzeichnung in mehreren Durchläufen des Aufzeichnungsträgers (1) durch die Belichtungsstation (9) erfolgt,
wobei in jedem Durchlauf die Bildaufzeichnung mit gepulstem Licht gleicher oder nahezu gleicher Lichtenergie erfolgt jedoch die Lichtenergie pro Durchlauf unterschiedlich ist
zur Erzeugung von Aufzeichnungen mit unterschiedlicher Aufzeichnungstiefe im Aufzeichnungsträger (1).

12. Verfahren nach einem der Ansprüche 1 bis 11,
**gekennzeichnet durch**
Verwendung monochromatischen Lichtes im ultravioletten Bereich oder
**durch** Verwendung nicht monochromatischen Lichtes mit einem Hauptanteil im ultravioletten Bereich.

13. Verfahren nach einem der Ansprüche 1 bis 12,
**gekennzeichnet durch**
seine Anwendung zur Erstellung fotographischer Vorlagen für gedruckte Leiterplatten.

14. Verfahren nach Anspruch 1,
**gekennzeichnet durch**
seine Anwendung zur Direktbelichtung von mit einer fotoempfindlichen Schicht versehenem Leiterplattenmaterial, welches aus einer elekrisch leitfähigen Metallschicht und einer nichtleitenden Trägerschicht besteht.

15. Verfahren nach einem der Ansprüche 1 bis 14,
**gekennzeichnet durch**
seine Anwendung zur Erstellung von Druckformen für den Hoch-, Tief-, Flach-, Durch- und Siebdruck.

16. Verfahren nach Anspruch 11,
**gekennzeichnet durch**
seine Anwendung zur Erstellung von dreidimensionalen Strukturen in der lichtempfindlichen Schicht für optische Elemente zur optischen oder Phasen-Fokussierung.

17. Verfahren nach einem der Ansprüche 1 bis 16,
**dadurch gekennzeichnet,**
**daß** die Aufzeichnung eines die Breite (b) der Belichtungsstation (2) übersteigenden Bildes in mehreren Durchläufen des Aufzeichnungsträgers (1) durch die Belichtungsstation (6) erfolgt, wobei in jedem Durchlauf eine Bildspalte (Sp1, Sp2, Sp3, Sp4..) des gedachten Gesamtbildes (IM) erzeugt wird.

18. Verfahren nach einem der Ansprüche 1 bis 17,
**dadurch gekennzeichnet, daß**
zur Verringerung meßtechnisch erfaßter Abweichungen von einer homogenen Aufzeichnungsstärke z für die einzelnen Bildpunkte an den Rasterpositionen des Aufzeichnungsträgers (1) - quer zur Bewegungsrichtung y des Aufzeichnungsträgers gesehen -

a) die Licht-Steuer-Elemente (c) computerprogrammgesteuert unter Berücksichtigung dieser Abweichungen derart gesteuert werden, daß bei der Erzeugung von Teilbildern Licht-Steuer-Elemente für Bildpunkte ursprünglich zu hoher Aufzeichnungsstärke deaktiviert werden;

b) zwischen der Licht-Steuer-Einheit (4) und dem Auf zeichnungsträger (1) ein diese Abweichungen ausgleichendes Filter angeordnet wird;

c) die Aufzeichnung des Bildes in mehreren Durchläufen des Aufzeichnungsträgers (1) durch die Belichtungsstation (6) erfolgt, wobei in jedem Durchlauf eine

Bildspalte (Sp1*, Sp2*) erzeugt wird und wobei benachbarte Bildstreifen randwärts einander teilweise (w*) überlappen.

19. Anordnung zur Aufzeichnung eines computergespeicherten Rasterbildes auf einen ebenen lichtempfindlichen Aufzeichnungsträger als ein aus Bildpunkten bestehendes Rasterbild in x/y Koordinatenrichtung, mit einer Licht-Steuer-Einheit (4*) und einer Verschiebe-Einheit für die Verschiebung des Aufzeichnungsträgers in y-richtung wobei das Rasterbild mittels Belichtung einer mit Steuermustern per Computerprogramm beaufschlagbaren Licht-Steuer-Einheit (4*) erzeugbar ist,
wobei die Licht-Steuer-Einheit (4*) aus matrixartig angeordneten Licht-Steuer-Elementen (c*) besteht, wobei ein Bildpunkt durch von einem Licht-Steuer-Element leitbaren Lichtstrahl an zugeordneter Position des Rasterbildes aufzeichenbar ist,
wobei der Aufzeichnungsträger gegenüber der Licht-Steuer-Einheit (oder umgekehrt) verschiebbar ist, wobei der Abstand der Ebenen, in welchen der Aufzeichnungsträger und die Licht-Steuer-Einheit (4*) liegen, gleichbleibend ist,
wobei für Belichtungszeitpunkte (t1, t2, t3,...) jeweils ein Steuermuster in die Licht-Steuer-Einheit (4*) ladbar ist für die Aufzeichnung eines Teilbildes (T1, T2, T3,...) in der Belichtungsstation, welches vom Steuermuster ableitbar ist,
wobei die Belichtungsstation immer die gleiche Position bezüglich der Licht-Steuer-Einheit (4*) einnimmt,
wobei die Aufzeichnung aller Bildpunkte eines Teilbildes (T1, T2, T3, T4,...) gleichzeitig erfolgt,
wobei der Aufzeichnungsträger zwischen zwei aufeianderfolgenden Belichtungszeitpunkten in y-richtung um eine äquidistante y-Verschiebestrecke verschiebbar ist,
wobei ein aufgezeichnetes Teilbild (T1) ein nachfolgend aufgezeichnetes Teilbild (T2) teilweise überlagert,
und wobei jedes aufgezeichnete Teilbild mit einem Teil des gedachten aufzuzeichnenden Rasterbildes auf dem Aufzeichnungsträger deckungsgleich ist,
wobei die y-Verschiebe-Strecke einen Wert hat, welcher einen Bruchteil der Länge einer Seite eines Bildpunktes einschließt,
daß zwischen der Licht-Steuer-Einheit (4*) und dem Aufzeichnungsträger (1*) eine Anordnung (6*) zum Versatz lichtpunkterzeugender Lichtstrahlen in x-Richtung angeordnet ist, wobei die x-Versatzstrecke einem Bruchteil der Länge (L) einer Seite eines Bildpunktes beträgt und der Maximalwert einer x-Versatzstrecke kleiner ist als die Länge (L) der Seite eines Bildpunktes,
**dadurch gekennzeichnet,**
**daß** die Licht-Steuer-Einheit (4*) in mehrere gedachte untereinanderliegende Streifenbereiche (ST1*, ST2*,ST3*, ST4*) aufgeteilt ist,
**daß** die Anordnung (6*) zum Versatz der Bildpunkte erzeugenden Lichtstrahlen optische Elemente (6-1* 6-2*, 6-3*, 6-4*) umfaßt,
die jeweils einem Streifenbereich (ST1*, ST2*,ST3*, ST4*) zugeordnet sind,
**daß** durch ein optisches Element (6-2*, 6-3*,6-4*) alle von den Licht-Steuer-Elementen eines Streifenbereiches ausgehenden Lichtstrahlen zur Aufzeichnung von Bildpunkten gemeinsam um jeweils die gleiche x-Versatzstrecke versetzbar sind und
**daß** der Versatz der von den einzelnen Streifenbereichen ausgehenden Lichtstrahlen jeweils unterschiedlich ist.

20. Anordnung nach Anspruch 19,
**dadurch gekennzeichnet, daß**
die optischen Elemente (6-2*, 6-3*, 6-4*) ebene Glasplatten gleicher Dicke sind, welche zur Bewirkung unterschiedlicher x-Versatzstrecken für die sie passierenden Lichtstrahlen unterschiedlich schräg zur Ebene der Licht-Steuer-Einheit angeordnet sind.

21. Anordnung nach Anspruch 20,

**dadurch gekennzeichnet, daß**
einem Streifenbereich (ST1*) eine Glasplatte (6-1*) in ebener (nicht schräger) Ausrichtung zugeordnet ist, welche keinen x-Versatz der sie passierenden Lichtstrahlen bedingt.

**22.** Anordnung nach Anspruch 19,
**dadurch gekennzeichnet,**
**daß** zwischen der Licht-Steuereinheit (4) und dem Aufzeichnungsträger (1) ein den Abbildungsmaßstab des Teilbildes bestimmendes Objektiv (7) angeordnet ist.

**23.** Anordnung nach Anspruch 19,
**dadurch gekennzeichnet,**
**daß** die y-Verschiebe-Einrichtung eine Schrittmotor-gesteuerte Einrichtung, eine Linearmotor-gesteuerte Einrichtung, eine piezokristall-gesteuerte Einrichtung oder eine Kombination vorgenannter Einrichtungen ist.

**Claims**

**1.** Process for tracing a computer-stored grid image on a flat photosensitive carrier, where the grid image consisting of grid dots is generated in x/y coordinate alignment by exposure of a light-controlling unit (4*) receiving control patterns from a computer program, where the light-controlling unit (4*) consists of light-controlling elements (c*) arranged as in a matrix, where a controlled beam of light for tracing an image dot on the tracing carrier is guided from each light-controlling element to a position assigned to it on a tracing surface in an exposure station,
where the tracing carrier moves with reference to the light-controlling unit (or vice versa), and where the distance between the levels at which the tracing carrier and the light-controlling unit (4*) lie remains constant,
where the tracing carrier executes a continuous or gradual movement in a straight line in the direction y with reference to the light-controlling unit (or vice versa),
where for each of the exposure moments (t1, t2, t3 ...) the light-controlling unit is loaded with a control pattern for tracing one partial image (T1, T2, T3 ...) derived from the control pattern on the tracing carrier in the exposure station,
where the exposure station always assumes the same position with reference to the light-controlling unit (4*),
where all the image dots of a partial image (T1, T2, T3 ...) are traced at the same time,
where the tracing carrier travels an equal y distance in y direction between two consecutive exposure moments,
**characterised in,**

a) **that** in process steps b), c) and d) certain image dots in a partial image (T1, T2, T3) are traced with an optical deflection distance of x in x direction with reference to imaginary undeflected image dots,
where the x deflection distance is equivalent to the amount $dx = (1/m)L = (1/m)$ multiplied by L for an integral $m = 2, 3, 4,...$ as a fraction of the length (L) of one side of an image dot (R) or the amount $(i)dx = (i)$ multiplied by dx as an integral multiple of dx for $i = 1, 2, 3, ... (m-1)$;
b)
**that** the light-controlling elements of the light-controlling unit (4) are assigned to imaginary horizontal strip areas (ST1, ST2, ST3, ...; STk for k=1 to m and for m= 2, 3, 4, ...) positioned beneath one another, where each strip area (ST1, ST2, ST3, ...) has the same number of light-controlling elements and the same number of rows of light-controlling elements,
c)
**that** the light-controlling elements in the upper first strip area (ST1) of the light-controlling unit are activated for the image dots to be traced without deflection in the x direction,
**that** the light-controlling elements for the x direction in the second strip area ST2 located under the first strip area (ST1) are activated by the x deflection distance = 1 x dx image dots to be traced with deflection,
**that** the light-controlling elements for the x direction in the third strip area ST3 which may be located under the second strip area (ST2) are activated by the x deflection distance = 2 x dx image dots to be traced with deflection,
**that** the light-controlling elements for the x direction in the fourth strip area (ST4) which may be located under the third strip area (ST3) are activated by the x deflection distance = 3 x dx image dots to be traced with-deflection,
and **that** the light-controlling elements located in any other strip areas are activated in a similar way to the sequence described above,
where the x deflection distance for image dots being traced increases by 1 x dx in each case from one strip area to the next strip area (ST1/ST2; ST2/ST3; ST3/ST4),
d)
**that** the light beams emitted by the light-controlling elements of a strip area of the light-controlling matrix are deflected together in order to trace image dots deflected in the x direction;
e)
**that** the optical deflection of the light beams in the x direction takes place at the same time for all the strip areas intended for such a deflection.

2. Process according to claim 1 **characterised in that** the y travel distance (dy) is of a size corresponding to fractions of the length L of an image dot, where dy = (1/s)L = (1/s) multiplied by L is for an integral number s = 2, 3, 4, ...;

3. Process according to claim 1 **characterised in that** the y travel distance is of a size corresponding to the equation
y travel distance = u x side length L of an image dot + k/m, where u = 1; 2; 3; ...
k = 1; 2; 3; ... (m-1) integral
m = number of strip areas = 2; 3; 4; ...
where y travel distances are excepted where, when written in unabbreviated numerator-denominator form, the numerator and denominator have a common divisor.

4. Process according to claims 1 and 2, **characterised in that** the y travel distance is equal to the smallest x deflection distance.

5. Process according to claim 1 **characterised in that** the light-controlling unit (4) is struck by pulsed light emitted by an LED unit (unit with light-emitting diodes).

6. Process according to claim 1 **characterised in that** the conversion of the computer grid image to controlled beams of light for tracing an image takes place by means of a semiconductor chip with tilting mirror elements which is struck by pulsed light.

7. Process according to claim 1 **characterised in that** the conversion of the computer grid image to controlled beams of light for tracing an image takes place via a matrix of controlled light-valve elements, or
the conversion of the computer grid image to controlled beams of light for tracing an image takes place via a matrix of elements emitting flashes of light.

8. Process according to claim 1 **characterised in that** the size of the partial image generated in the exposure station (6) is determined by a scaling lens (7) arranged between the light-controlling unit (4) and the tracing carrier (1).

9. Process according to any of the claims 1 to 8 **characterised in that** the tracing carrier (1) travels with continuous or gradual motion with reference to the light-controlling unit (4).

10. Process according to any of the claims 1 to 9 **characterised in that** the image is traced with flashes of pulsed light of equal or virtually equal energy in order to create a constant trace depth in the tracing carrier (1).

11. Process according to any of the claims 1 to 10 **characterised in that** the image is traced in several passages of the tracing carrier (1) through the exposure station (9), where the tracing of the image takes place with pulsed light of equal or virtually equal energy at each pass, but that the energy of the light differs at each pass in order to create traces of varying depth in the tracing carrier (1).

12. Process according to any of the claims 1 to 11 **characterised by** the use of monochromatic light in the ultra-violet range or the use of non-monochromatic light, the main fraction of which is in the ultra-violet range.

13. Process according to any of the claims 1 to 12 **characterised by** its use to manufacture photographic patterns for printed circuit boards.

14. Process according to claim 1 **characterised by** its use for the direct exposure of circuit-board material coated with a photo-sensitive layer, the said circuit-board material consisting of an electrically conductive metallic layer and a non-conductive carrier layer.

15. Process according to any of the claims 1 to 14 **characterised by** its use to manufacture printing forms for the letterpress, rotogravure, flatbed, screen and silk-screen printing processes.

16. Process according to claim 11 **characterised by** its use for creating three-dimensional structures in the photo-sensitive layer for optical elements for optical or phase-focussing.

**17.** Process according to any of the claims 1 to 16 **characterised in that** the tracing of an image whose width (b) exceeds that of the exposure station (2) takes place in several passes of the tracing carrier (1) through the exposure station (6), where with each pass, one column (Sp1, Sp2, Sp3, Sp4 ...) of the imaginary overall image (IM) is generated.

**18.** Process according to any of the claims 1 to 17 **characterised in that**, in order to reduce measured deviations from a homogeneous tracing depth z for the individual image dots at the grid positions of the tracing carrier (1) (viewed at right angles to the direction of travel y of the tracing carrier) a) the light-controlling elements (c) are controlled by a computer program taking account of these deviations in such a way that, when generating partial images, light-controlling elements for image dots, whose tracing intensity was originally too high, are deactivated;

b) a filter is arranged between the light-controlling unit (4) and the tracing carrier (1) in order to compensate for these deviations;
c) the image is traced in several passes of the tracing carrier (1) through the exposure station (6) where, at each pass, one image column (Sp1*, Sp2*) is generated and where adjacent image strips partially (w*) overlap one another towards the edge.

**19.** Arrangement for tracing a computer-stored grid image on a flat photosensitive carrier as a grid image in x/y coordinate alignment consisting of image dots, with a light-controlling unit (4*) and a travelling unit for moving the tracing carrier in the y direction, where the grid image is generated by exposing a light-controlling unit (4*) to which program-generated control patterns are applied, where the light-controlling unit (4*) consists of light-controlling elements (c*) arranged as in a matrix, where an image dot is traced at an assigned position on the grid image by a beam of light guided by a light-controlling element, where the tracing carrier moves with reference to the light-controlling unit (or vice versa),
where the distance between the levels at which the tracing carrier and the light-controlling unit (4*) lie is constant, where a control pattern for each of the exposure times (t1, t2, t3, ...) is loaded into the light-controlling unit (4*) in order to trace a partial image (T1, T2, T3, ...) in the exposure station which is derived from the control pattern, where the exposure station always assumes the same position with reference to the light-controlling unit (4*),
where all the image dots of a partial image (T1, T2, T3, ...) are traced at the same time,
where the tracing carrier is moved by an equal y distance in y direction between successive moments of exposure, where a traced partial image (T1) partially overlaps a partial image (T2) traced subsequently and where each traced partial image
coincides with part of the imaginary grid image to be traced on the tracing carrier,
where the y distance has a value which includes a fraction of the length of one side of an image dot,
that an arrangement (6*) for deflecting the beams of light generating the light dots in x direction is located between the light-controlling unit (4*) and the tracing carrier (1*), where the x deflection distance is a fraction of the length (L) of one side of an image dot and the maximum value of an x deflection distance is less than the length (L) of the side of an image dot,
**characterised in,**
**that** the light-controlling unit (4*) is divided into several imaginary strip areas (ST1*, ST2*, ST3*, ST4*) positioned below one another,
**that** the arrangement (6*) for deflecting the light beams generating the image dots comprises optical elements (6-1*, 6-2*, 6-3*, 6-4*),
each of which is assigned to one strip area (ST1*, ST2*, ST3*, ST4*),
**that** all the light beams emitted by the light-controlling elements of a strip area through an optical element (6-2*, 6-3*, 6-4*) are deflected together each time by the same x distance in order to trace image dots, and
**that** the deflection of the light beams emitted by the individual strip areas differs in each case.

**20.** Arrangement according to claim 19, **characterised in that** the optical elements (6-2*, 6-3*, 6-4*) are flat plates of glass of the same thickness which are arranged at an angle to the level of the light-controlling unit in order to achieve different x deflection distances for the light beams passing through them.

**21.** Arrangement according to claim 20, **characterised in that** one glass plate (6-1*) aligned flat (i.e. not at an angle) is assigned to one strip area (ST1*) and does not cause any x deflection of the light beams passing through it.

**22.** Arrangement according to claim 19, **characterised in that** a lens (7) which defines the imaging scale of the partial image is arranged between the light-controlling unit (4) and the tracing carrier (1).

**23.** Arrangement according to claim 19, **characterised in that** the device for moving in the y travel direction is controlled by a stepping motor, a linear motor, a piezoelectric crystal device or a combination of the above devices.

**Revendications**

**1.** Procédé pour enregistrer une image tramée mémorisée par un ordinateur sur un support d'enregistrement photosensible plan sous la forme d'une image tramée composée de points d'image dans la direction de coordonnées x/y, dans lequel l'image tramée est obtenue par éclairage d'une unité de commande de lumière (4*) exposée à des motifs de dispersion par un programme informatique,
dans lequel l'unité de commande de la lumière (4*) se compose d'éléments de commande de la lumière (c*) disposés pour former une matrice, chaque élément de commande de la lumière pouvant guider un faisceau lumineux contrôlable pour enregistrer un point d'image sur le support d'enregistrement vers une position qui lui est affectée sur une surface d'enregistrement dans une station d'insolation,
dans lequel le support d'enregistrement est déplacé par rapport à l'unité de commande de la lumière (ou vice versa), la distance entre les plans dans lesquels se trouvent le support d'enregistrement et l'unité de commande de la lumière (4*) restant la même,
dans lequel le support d'enregistrement exécute par rapport à l'unité de commande de la lumière (ou vice versa) un mouvement rectiligne continu ou pas à pas dans le sens de l'axe y,
dans lequel, pour des moments d'insolation (t1, t2, t3...), un motif de commande est chargé pour chacun dans l'unité de commande de la lumière en vue de l'enregistrement d'une image partielle (T1, T2, T3...) dérivée du motif de dispersion dans la station d'insolation, dans lequel la station d'insolation prend toujours la même position par rapport à l'unité de commande de la lumière (4*),
dans lequel l'enregistrement de tous les points d'image d'une image partielle (T1, T2, T3...) a lieu simultanément, dans lequel le support d'enregistrement est déplacé dans le sens de l'axe y d'une distance de déplacement sur l'axe y égale entre deux moments d'insolation successifs,
**caractérisée en ce que**

a) certains points d'image dans une image partielle (T1, T2, T3,) sont enregistrés avec un décalage optique dans le sens de l'axe x d'une distance de décalage sur l'axe x en tenant compte des étapes de procédé b), c) et d), la distance de décalage sur l'axe x ayant la valeur

$$dx = (1/m)L = (1/m) \text{ multiplié par } L$$

pour une valeur entière de m = 2, 3, 4... représentant une fraction de la longueur (L) d'un côté d'un point d'image (R)
ou la valeur
(i)dx = (i) multiplié par dx
représentant un multiple entier de dx pour i= 1, 2, 3...(m-1) ;
b) **en ce que** les éléments de commande de la lumière de l'unité de commande de la lumière (4) sont associés à des zones de bandes horizontales imaginaires situées les unes en dessous des autres (ST1, ST2, ST3,... ; STk pour k= 1 à m et pour m = 2, 3, 4...), chaque zone de bande (ST1, ST2, ST3,...) contenant le même nombre d'éléments de commande de la lumière et le même nombre de rangées d'éléments de commande de la lumière,
c) **en ce que** dans la première zone de bande supérieure (ST1) de l'unité de commande de la lumière, les éléments de commande de la lumière sont activés pour des points d'image à enregistrer sans décalage sur l'axe x,
**en ce que** dans la deuxième zone de bande (ST2) située sous la première zone de bande (ST1), les éléments de commande de la lumière sont activés pour les points d'image à enregistrer décalés dans le sens de l'axe x de la distance de décalage sur l'axe x = 1 x dx,
**en ce que** dans la troisième zone de bande (ST3) située éventuellement sous la deuxième zone de bande (ST2), les éléments de commande de la lumière sont activés pour les points d'image à enregistrer décalés dans le sens de l'axe x de la distance de décalage sur l'axe x = 2 x dx,
**en ce que** dans la quatrième zone de bande (ST4) située éventuellement sous la troisième zone de bande (ST3), les éléments de commande de la lumière sont activés pour les points d'image à enregistrer décalés dans le sens de l'axe x de la distance de décalage sur l'axe x = 3 x dx,

et **en ce que** dans les autres zones de bande éventuelles, les éléments de commande de la lumière sont activés de manière analogue aux étapes précédentes,

la distance de décalage sur l'axe x pour les points d'image à enregistrer augmentant de 1 x dx à la fois d'une zone de bande à l'autre (ST1/ST2, ST2/ST3, ST3/ST4...),

d) **en ce que** les faisceaux lumineux partant des éléments de commande de la lumière

d'une zone de bande de la matrice de commande de la lumière sont décalés ensemble pour enregistrer des points d'image décalés dans le sens de l'axe x,

e) **en ce que** le décalage optique des faisceaux lumineux sur l'axe x s'effectue simultanément pour toutes les zones de bande concernées par ce décalage.

2. Procédé selon la revendication 1, **caractérisé en ce que** la distance de décalage sur l'axe y (dy) a une valeur correspondant aux fractions de la longueur L d'un point d'image, où dy= (1/s)L = (1/s) multiplié par L pour une valeur entière de s= 2, 3, 4...

3. Procédé selon la revendication 1, **caractérisé en ce que** la distance de translation sur l'axe y a une valeur définie par la relation :

$$\text{distance de translation sur l'axe y} = u \times \text{longueur du côté L d'un point d'image} + k/m$$

u=1;2;3...

k = 1 ; 2 ; 3 ... (m-1) entier

m = nombre des zones de bande = 2 ; 3 ; 4 ; ...

en excluant les distances de translation sur l'axe y auxquelles les numérateurs et dénominateurs, en écriture des numérateurs/dénominateurs non abrégée, ont un diviseur commun.

4. Procédé selon les revendications 1 et 2, **caractérisé en ce que** la distance de translation sur l'axe y est égale à la plus petite distance de décalage sur l'axe x.

5. Procédé selon la revendication 1, **caractérisé en ce que** l'unité de commande de la lumière (4) est exposée à une lumière pulsée provenant d'une unité de DEL (unité de diodes électroluminescentes).

6. Procédé selon la revendication 1, **caractérisé en ce que** la transformation de l'image d'ordinateur tramée en faisceaux lumineux contrôlables pour l'enregistrement de l'image est réalisée à l'aide d'une puce de semi-conducteur à éléments de miroir inclinés exposée à une lumière pulsée.

7. Procédé selon la revendication 1, **caractérisé en ce que** la transformation de l'image d'ordinateur tramée en faisceaux lumineux contrôlables pour l'enregistrement de l'image est réalisée à l'aide d'éléments de valve optique contrôlables par une matrice

ou

**caractérisé en ce que** la transformation de l'image d'ordinateur tramée en faisceaux lumineux contrôlables pour l'enregistrement de l'image est réalisée à l'aide d'une matrice d'éléments émettant des éclats lumineux.

8. Procédé selon la revendication 1, **caractérisé en ce que** la taille des images partielles produites dans la station d'insolation (6) est déterminée par un objectif (7) déterminant l'échelle disposé entre l'unité de commande de la lumière (4) et le support d'enregistrement (1).

9. Procédé selon l'une des revendications 1 à 8, **caractérisé en ce que** le support d'enregistrement (1) est décalé par rapport à l'unité de commande de la lumière (4) selon un mouvement continu ou pas à pas.

10. Procédé selon l'une des revendications 1 à 9, **caractérisé en ce que** l'enregistrement de l'image est effectué avec de la lumière pulsée ayant une énergie d'éclats égale ou presque égale afin de produire une profondeur d'enregistrement constante dans le support d'enregistrement (1).

11. Procédé selon l'une des revendications 1 à 10, **caractérisé en ce que** l'enregistrement de l'image est réalisé en plusieurs passages du support d'enregistrement (1) à travers la station d'insolation (9), l'enregistrement de l'image étant exécuté avec de la lumière pulsée d'énergie égale ou presque égale à chaque passage mais avec une énergie lumineuse différente à chaque passage, afin d'obtenir des enregistrement ayant une profondeur d'enregistrement différente dans le support d'enregistrement (1).

**12.** Procédé selon l'une des revendications 1 à 11, **caractérisé en ce qu'**il met en oeuvre de la lumière monochromatique dans le domaine de l'ultraviolet ou de la lumière non monochromatique dont une composante principale se situe dans le domaine de l'ultraviolet.

**13.** Procédé selon l'une des revendications 1 à 12, **caractérisé en ce qu'**il est utilisé pour créer des modèles photographiques pour des cartes de circuits imprimés.

**14.** Procédé selon la revendication 1, **caractérisé en ce qu'**il est utilisé pour l'insolation directe d'un matériau de carte de circuits revêtu d'une couche photosensible, qui est composé d'une couche métallique conductrice électrique et d'une couche de support non conductrice.

**15.** Procédé selon l'une des revendications 1 à 14, **caractérisé en ce qu'**il est utilisé pour créer des clichés d'impression pour l'impression typographique, en taille douce, en planographie au stencil et en sérigraphie.

**16.** Procédé selon la revendication 11, **caractérisé en ce qu'**il est utilisé pour créer des structures à trois dimensions dans la couche photosensible pour des éléments optiques servant à la focalisation optique ou de phase.

**17.** Procédé selon l'une des revendications 1 à 16, **caractérisé en ce que** l'enregistrement d'une image dépassant la largeur (b) de la station d'insolation (2) s'effectue en plusieurs passages du support d'enregistrement (1) à travers la station d'insolation (6), une colonne d'image (Sp1, Sp2, Sp3, Sp4...) de l'image d'ensemble (IM) imaginaire étant créée à chaque passage.

**18.** Procédé selon l'une des revendications 1 à 17, **caractérisé en ce qu'**afin de réduire les écarts mesurés d'une épaisseur d'enregistrement (z) homogène pour les différents points d'image aux positions tramée du support d'enregistrement (1), vu transversalement par rapport au sens de déplacement sur l'axe y du support d'enregistrement,

> a) les éléments de commande de la lumière (c) sont commandés par un ordinateur en tenant compte de ces écarts de telle façon que lors de la création d'images partielles, les éléments de commande de la lumière pour des points d'image dont l'intensité est initialement trop élevée sont désactivés ;
> b) un filtre compensant ces écarts est disposé entre l'unité de commande de la lumière (4) et le support d'enregistrement (1) ;
> c) l'enregistrement de l'image est réalisé en plusieurs passages du support d'enregistrement (1) à travers la station d'insolation (6), une colonne d'image (Sp1*, Sp2*) étant créée à chaque passage et les bords de bandes d'image voisines se chevauchant partiellement (w*).

**19.** Installation pour enregistrer une image tramée mémorisée par un ordinateur sur un support d'enregistrement photosensible plan sous la forme d'une image tramée composée de points d'image dans la direction de coordonnées x/y, avec une unité de commande de la lumière (4*) et une unité de déplacement pour le déplacement du support d'enregistrement dans le sens de l'axe y,
dans lequel l'image tramée peut être obtenue par éclairage d'une unité de commande de lumière (4*) exposée à des motifs de dispersion par un programme informatique,
dans lequel l'unité de commande de la lumière (4*) se compose d'éléments de commande de la lumière (c*) disposés pour former une matrice, un point d'image pouvant être enregistré par un faisceaux lumineux qui peut être guidé par un élément de commande de la lumière vers une position de l'image tramée qui lui est affectée,
dans lequel le support d'enregistrement peut être déplacé par rapport à l'unité de commande de la lumière (ou vice versa), la distance entre les plans dans lesquels se trouvent le support d'enregistrement et l'unité de commande de la lumière (4*) restant la même,
dans lequel, pour des moments d'insolation (t1, t2, t3...), un motif de commande peut être chargé pour chacun dans l'unité de commande de la lumière (4*) en vue de l'enregistrement d'une image partielle (T1, T2, T3...) dérivée du motif de dispersion dans la station d'insolation,
dans lequel la station d'insolation prend toujours la même position par rapport à l'unité de commande de la lumière (4*),
dans lequel l'enregistrement de tous les points d'image d'une image partielle (T1, T2, T3, T4...) a lieu simultanément,
dans lequel le support d'enregistrement est déplacé dans le sens de l'axe y d'une distance de déplacement sur l'axe y égale entre deux moments d'insolation successifs,

dans lequel une image partielle (T1) enregistrée est partiellement recouverte par une image partielle (T2) enregistrée après elle,

et dans lequel chaque image partielle coïncide avec une partie de l'image tramée imaginaire à enregistrer sur le support d'enregistrement,

la distance de déplacement sur l'axe y ayant une valeur qui inclut une fraction de la longueur d'un côté d'un point d'image,

dans lequel est disposé entre l'unité de commande de la lumière (4*) et le support d'enregistrement (1*) un dispositif (6*) pour décaler des faisceaux lumineux créant les points d'image dans le sens de l'axe x, la distance de décalage sur l'axe x représentant une fraction de la longueur (L) d'un côté d'un point d'image et la valeur maximale d'une longueur de décalage sur l'axe x étant inférieure à la longueur (L) du côté d'un point d'image,

**caractérisée en ce que**

l'unité de commande de la lumière (4*) est partagée en plusieurs zones de bande (ST1*, ST2*, ST3*, ST4*) imaginaires situées les unes en dessous des autres,

**en ce que** le dispositif (6*) pour décaler des faisceaux lumineux créant les points d'image comprend des éléments optiques (6-1* 6-2*, 6-3*, 6-4*) qui sont associés chacun à une zone de bande (ST1*, ST2*, ST3*, ST4*),

**en ce qu'**un élément optique (6-2*, 6-3*,6-4*) peut décaler tous les faisceaux lumineux partant des éléments de commande de la lumière d'une zone de bande ensemble de la même distance de décalage sur l'axe x pour enregistrer les points d'image et

**en ce que** le décalage des faisceaux lumineux partant de chacune des différentes zones de bande est différent.

20. Installation selon la revendication 19, **caractérisée en ce que** les éléments optiques ( 6-2*, 6-3*, 6-4*) sont des plaques de verre plane de même épaisseur, qui sont disposées de façon à créer des distances de décalage sur l'axe x différentes pour les faisceaux lumineux qui les traversent avec une obliquité différente par rapport au plan de l'unité de commande de la lumière.

21. Installation selon la revendication 20, **caractérisée en ce qu'**une zone de bande (ST1*) est associée à une plaque de verre (6-1*) dans une orientation plane (non oblique) qui ne produit pas de décalage sur l'axe x des faisceaux lumineux qui la traversent.

22. Installation selon la revendication 19, **caractérisée en ce qu'**un objectif (7) déterminant l'échelle de représentation de l'image partielle est disposé entre l'unité de commande de la lumière (4) et le support d'enregistrement (1).

23. Installation selon la revendication 19, **caractérisée en ce que** le dispositif de déplacement sur l'axe y est un dispositif commandé par un moteur pas à pas, un dispositif commandé par un moteur linéaire, un dispositif commandé par un cristal piézoélectrique ou une combinaison de ces dispositifs.

**FIG.1**

**FIG.2**

**FIG.3**

FIG. 4

**FIG. 5A**

**FIG. 5B**

EP 2 116 901 B1

**FIG. 6B**

**FIG. 6A**

**FIG. 7A**

**FIG. 7B**

EP 2 116 901 B1

EP 2 116 901 B1

ST1

ST2

X

C3-1

**FIG.8A**

P4

S1

S2

K

T4

**FIG.8B**

**FIG. 9A**

**FIG. 9B**

EP 2 116 901 B1

FIG.10A

FIG.10B

EP 2 116 901 B1

FIG.11

FIG.12

FIG.13A

FIG.14A

FIG.13B

FIG.14B

$Y=\frac{1}{4}L$

$Y=\frac{5}{4}L$

$Y=\frac{7}{4}L$

FIG.15

FIG.17

FIG.16

EP 2 116 901 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102007051990931
- US 5995129 A

- US 5005129 A

**In der Beschreibung aufgeführte Nicht-Patentliteratur**

- **HECHT ; ZAJAC.** OPTICS. Addison-Wesley Publishing Company, 1974